# EUROPEAN PATENT APPLICATION

(11) **EP 4 043 512 A1**
(43) Date of publication of application: **17.08.2022**
(21) Application number: 20873565.4
(22) Date of filing: 07.10.2020
(51) Int. Cl.: C08G 73/02, H01L 51/50

(54) **ORGANIC ELECTROLUMINESCENCE ELEMENT HAVING ORGANIC LAYER COMPRISING HIGH MOLECULAR WEIGHT COMPOUND**

(30) Priority: 09.10.2019 JP 2019185719
(71) Applicant: Hodogaya Chemical Co., Ltd., Tokyo 104-0028 (JP)
(72) Inventor: TOGASHI, Kazunori, Tokyo 104-0028 (JP); SHINODA, Mika, Tokyo 104-0028 (JP); IZUMIDA, Junichi, Tokyo 104-0028 (JP); MOCHIZUKI, Shunji, Tokyo 104-0028 (JP); HIRAI, Hiroki, Tokyo 104-0028 (JP); SAEGUSA, Yuta, Tokyo 104-0028 (JP)
(74) Representative: Forstmeyer, Dietmar
(86) International application number: PCT/JP2020/038045
(87) International publication number: WO 2021/070878

(57) **Abstract**

It is an object of the present invention to provide a polymer organic EL element that has a low driving voltage, high light emission efficiency, and a long lifespan. The present invention provides an organic electroluminescence element having a pair of electrodes and at least one organic layer between the electrodes, wherein the organic layer is constituted by two or more high molecular weight compounds including at least high molecular weight compounds α and β, and the high molecular weight compound α has a substituted triarylamine structural unit represented by a general formula (1) below and has a weight average molecular weight of 10,000 or more and less than 1,000,000 in terms of polystyrene. For the symbols in the formula, see the Description.

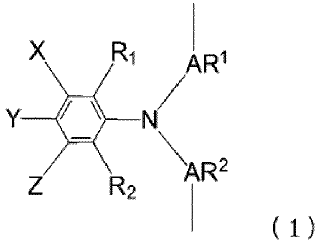

## Description

### Technical Field

The present invention relates to an organic electroluminescence element (organic EL element) that is a self-emissive element suitably used in various types of display apparatuses.

### Background Art

Active studies have been carried out on organic EL elements that are self-emissive elements and are brighter than liquid crystal elements, have superior display viewability, and can provide a clearer display.

An organic EL element has a configuration in which a thin film (organic layer) made of an organic compound is interposed between a positive electrode and a negative electrode. A method for forming the thin film can be roughly classified as a vacuum deposition method or a coating method. The vacuum deposition method is a method in which a thin film is formed on a substrate in vacuum using mainly a low molecular compound, and this technique is already in practical use. On the other hand, the coating method is a method in which a thin film is formed on a substrate through inkjet printing, printing, or the like using a solution composed mainly of a high molecular compound. This method is a technique that is essential for future large area organic EL displays because it has high material usage efficiency and is suitable for larger area and higher resolution displays.

The vacuum deposition method in which a low molecular material is used has low material usage efficiency, and the larger the substrate, the larger the shadow mask warpage, making uniform deposition on large substrates difficult. There is also the issue of the production cost being high.

On the other hand, with a polymer material, a uniform film can be formed even on a large substrate by applying a solution prepared by dissolving the polymer material in an organic solvent. Thus, a coating method as typified by an inkjet printing method or a printing method can be used. Accordingly, the material usage efficiency can be increased, and the cost of producing elements can thus be reduced significantly.

Various studies have been conducted on organic EL elements in which a polymer material is used. However, there is still a problem in that element characteristics such as light emission efficiency and lifespan are not necessarily sufficient (see Patent Literatures 1 to 5, for example).

A fluorene polymer called TFB is known as a typical hole transport material that has been used in polymer organic EL elements (see Patent Literatures 6 and 7). However, TFB has insufficient hole transportability and insufficient electron block ability. Accordingly, there is a problem in that some electrons pass through a light emitting layer, and thus an improvement in light emission efficiency cannot be expected. There is also another problem in that TFB has low film adhesion to adjacent layers, and thus an increase in the lifespan of elements cannot be expected.

Also, the inventors of the present invention have previously developed various types of hole transport materials (see Patent Literatures 8 and 9) for use in polymer organic EL elements. However, there is a problem in that the lifespan of elements is still insufficient.

### Citation List

### Patent Literature

Patent Literature 1: US 20080274303
Patent Literature 2: US 8274074
Patent Literature 3: US 20100176377
Patent Literature 4: US 20100084965
Patent Literature 5: WO 2005/049546
Patent Literature 6: US 2001026878
Patent Literature 7: WO 2005/059951
Patent Literature 8: US 20190326515
Patent Literature 9: US 20190378989

### Summary of Invention

It is an object of the present invention to provide a polymer organic EL element having an organic layer (thin film) made of a polymer material, wherein the organic EL element has a longer lifespan than conventional organic EL elements.

The inventors of the present invention found that an organic EL element having an organic layer that is formed using a solution in which two or more high molecular weight compounds are dissolved has a longer lifespan than an organic EL element having an organic layer that is formed using a solution in which a single high molecular weight compound is dissolved, and thus accomplished the present invention.

That is to say, the present invention relates to an organic EL element having a pair of electrodes and at least one organic layer between the electrodes, wherein the organic layer is constituted by two or more high molecular weight compounds.

Specifically, the organic layer is constituted by two or more high molecular weight compounds including at least a high molecular weight compound α and a high molecular weight compound β, and the high molecular weight compound α is a high molecular weight compound that has a substituted triarylamine structural unit represented by a general formula (1) below and that has a weight average molecular weight of 10,000 or more and less than 1,000,000 in terms of polystyrene.

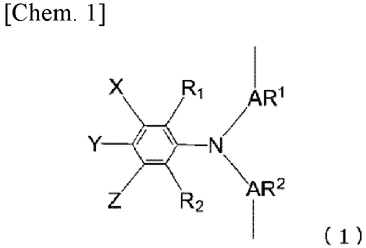

In the above formula, AR¹ and AR² each independently represent a divalent aryl group or a divalent heteroaryl group,

R₁ and R₂ each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms, and

X, Y, and Z each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, a cycloalkyloxy group having 5 to 10 carbon atoms, an aryl group, or a heteroaryl group, where at least one of X, Y, and Z is an aryl group or a heteroaryl group.

In the high molecular weight compound α, the following is preferable:
(1) in the general formula (1), R₁ and R₂ each independently represent a hydrogen atom or a heavy hydrogen atom, and X and Y each independently represent an aryl group or a heteroaryl group;
(2) in the general formula (1), R₁ and R₂ represent hydrogen atoms, and X and Y each independently represent a phenyl group, a biphenylyl group, a terphenyl group, a naphthyl group, a phenanthrenyl group, a fluorenyl group, a naphthylphenyl group, a triphenylenyl group, a dibenzofuranyl group, or a dibenzothienyl group; and
(3) the high molecular weight compound α has at least one structural unit selected from structural units that have an aromatic hydrocarbon ring and that are represented by general formulae (2a) to (2x) below.

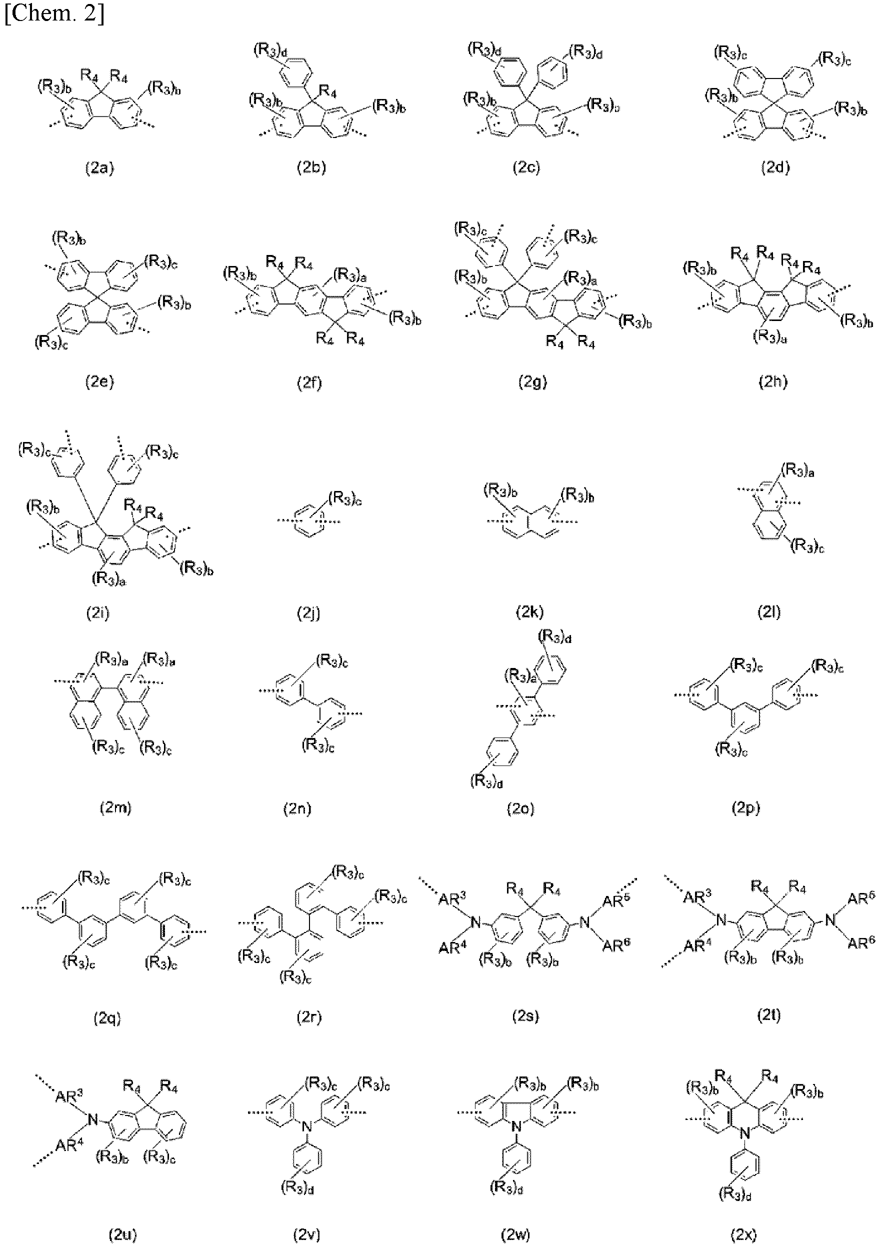

In the above formulae, R₃ each independently represent a heavy hydrogen atom, a cyano group, a nitro group, a fluorine atom, a chlorine atom, a bromine atom, an iodine atom, or an alkyl group, a cycloalkyl group, an alkyloxy group, a cycloalkyloxy group, a thioalkyloxy group, an alkenyl group, or an aryloxy group, the alkyl group, the cycloalkyl group, the alkyloxy group, the cycloalkyloxy group, the thioalkyloxy group, the alkenyl group and the aryloxy group having not more than 40 (in particular, 3 to 40) carbon atoms,
R₄ represents an alkyl group, a cycloalkyl group, an alkyloxy group, a thioalkyloxy group, or a cycloalkyloxy group, the alkyl group, the cycloalkyl group, the alkyloxy group, the thioalkyloxy group and the cycloalkyloxy group having not more than 40 (in particular, 3 to 40) carbon atoms,
AR³ to AR⁶ each independently represent a monovalent or divalent aryl or heteroaryl group, and
a to d are the numbers of R₃, and each independently represent an integer below:
   a = 0, 1, or 2,
   b = 0, 1, 2, or 3,
   c = 0, 1, 2, 3, or 4, and
   d = 0, 1, 2, 3, 4, or 5.

Also, in the high molecular weight compound α, the following is preferable:
(4) the high molecular weight compound α has a thermal crosslinkable structural unit; and
(5) the thermal crosslinkable structural unit is at least one structural unit selected from structural units represented by general formulae (3a) to (3z) below.

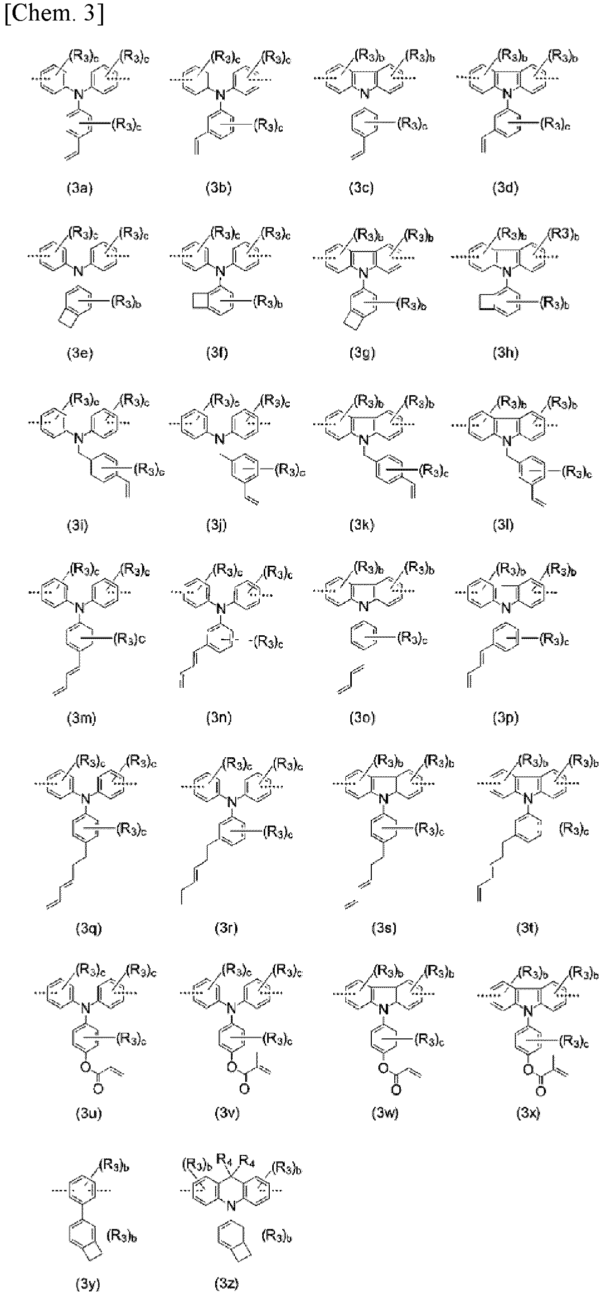

In the above formulae, R₃, R₄, and a to c are as defined in the general formulae (2a) to (2x).

The high molecular weight compound β is a high molecular weight compound that has a repeating unit constituted by a triarylamine structural unit represented by a general formula (4) below and a bonding structural unit represented by a general formula (5) below, wherein the repeating unit is represented by a general formula (6) below, and that has a weight average molecular weight of 10,000 or more and less than 1,000,000 in terms of polystyrene.

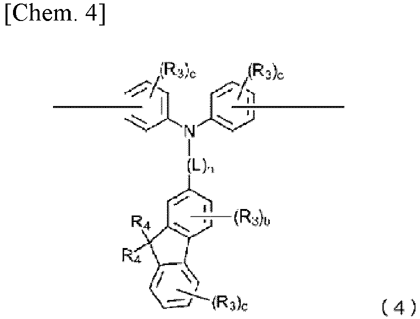

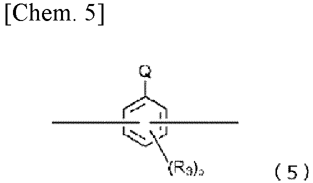

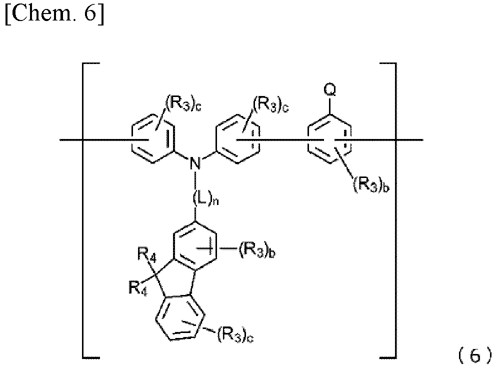

In the above formulae, R₃, R₄, b, and c are as defined in the general formulae (2a) to (2x),
Q represents a hydrogen atom, a heavy hydrogen atom, an amino group, an aryl group, or a heteroaryl group,
L represents a divalent phenyl group, and
n represents an integer of 0 to 3.

In the high molecular weight compound β, the following is preferable:
(1) R₃ is not present, or R₃ represents a heavy hydrogen atom, and Q represents a hydrogen atom or a heavy hydrogen atom;
(2) the high molecular weight compound β has a thermal crosslinkable structural unit; and
(3) the thermal crosslinkable structural unit is at least one structural unit selected from structural units represented by the general formulae (3a) to (3z).

In the organic EL element of the present invention, it is preferable that the organic layer is a hole transport layer, an electron blocking layer, a hole injection layer, or a light emitting layer.

### Advantageous Effects of Invention

The above-described high molecular weight compound α has a substituted triarylamine structural unit represented by the general formula (1), preferably has a structural unit having an aromatic hydrocarbon ring, in particular, at least one structural unit selected from structural units represented by the general formulae (2a) to (2x), preferably has a thermal crosslinkable structural unit, in particular, at least one structural unit selected from structural units represented by the general formulae (3a) to (3z), and preferably has a weight average molecular weight within a range of 10,000 or more and less than 1,000,000 in terms of polystyrene when measured using GPC (gel permeation chromatography).

The high molecular weight compound α has the following characteristics:
(1) good hole injectability;
(2) high hole mobility;
(3) excellent electron block ability;
(4) stable thin film state; and
(5) excellent heat resistance.

The above-described high molecular weight compound β has a repeating unit represented by the general formula (6), preferably has a thermal crosslinkable structural unit, in particular, at least one structural unit selected from structural units represented by the general formulae (3a) to (3z), and preferably has a weight average molecular weight within a range of 10,000 or more and less than 1,000,000 in terms of polystyrene when measured using GPC.

The high molecular weight compound β has the characteristics of having a wide bandgap, in addition to the above-described characteristics (1) to (5).

An organic EL element of the present invention in which an organic layer that is formed using a solution in which two or more high molecular weight compounds including the above-described high molecular weight compounds α and β are dissolved is provided between a pair of electrodes as, for example, a hole transport layer, an electron blocking layer, a hole injection layer, or a light emitting layer has the following advantages:
(1) high light emission efficiency and high power efficiency; and
(2) a long lifespan.

### Brief Description of Drawings

[Fig. 1] Chemical structures of structural units 1 to 9 that are preferable as a substituted triarylamine structural unit represented by the general formula (1) included in a high molecular weight compound used in the present invention.
[Fig. 2] Chemical structures of structural units 10 to 18 that are preferable as a substituted triarylamine structural unit represented by the general formula (1) included in a high molecular weight compound used in the present invention.
[Fig. 3] Chemical structures of structural units 19 to 26 that are preferable as a substituted triarylamine structural unit represented by the general formula (1) included in a high molecular weight compound used in the present invention.
[Fig. 4] Chemical structures of structural units 27 to 32 that are preferable as a substituted triarylamine structural unit represented by the general formula (1) included in a high molecular weight compound used in the present invention.
[Fig. 5] Chemical structures of structural units 33 to 38 that are preferable as a substituted triarylamine structural unit represented by the general formula (1) included in a high molecular weight compound used in the present invention.
[Fig. 6] Chemical structures of structural units 39 to 47 that are preferable as a substituted triarylamine structural unit represented by the general formula (1) included in a high molecular weight compound used in the present invention.
[Fig. 7] Chemical structures of structural units 48 to 56 that are preferable as a substituted triarylamine structural unit represented by the general formula (1) included in a high molecular weight compound used in the present invention.
[Fig. 8] Chemical structures of structural units 57 to 68 that are preferable as a substituted triarylamine structural unit represented by the general formula (1) included in a high molecular weight compound used in the present invention.
[Fig. 9] Chemical structures of structural units 69 to 79 that are preferable as a substituted triarylamine structural unit represented by the general formula (1) included in a high molecular weight compound used in the present invention.
[Fig. 10] Chemical structures of structural units 80 to 88 that are preferable as a substituted triarylamine structural unit represented by the general formula (1) included in a high molecular weight compound used in the present invention.
[Fig. 11] Chemical structures of structural units 89 to 99 that are preferable as a substituted triarylamine structural unit represented by the general formula (1) included in a high molecular weight compound used in the present invention.
[Fig. 12]Chemical structures of structural units 100 to 108 that are preferable as a substituted triarylamine structural unit represented by the general formula (1) included in a high molecular weight compound used in the present invention.
[Fig. 13]Chemical structures of structural units 109 to 117 that are preferable as a substituted triarylamine structural unit represented by the general formula (1) included in a high molecular weight compound used in the present invention.
[Fig. 14]Chemical structures of structural units 118 to 126 that are preferable as a substituted triarylamine structural unit represented by the general formula (1) included in a high molecular weight compound used in the present invention.
[Fig. 15]Chemical structures of structural units 127 to 135 that are preferable as a substituted triarylamine structural unit represented by the general formula (1) included in a high molecular weight compound used in the present invention.
[Fig. 16]Chemical structures of structural units 136 to 144 that are preferable as a substituted triarylamine structural unit represented by the general formula (1) included in a high molecular weight compound used in the present invention.
[Fig. 17]Chemical structures of structural units 145 to 156 that are preferable as a substituted triarylamine structural unit represented by the general formula (1) included in a high molecular weight compound used in the present invention.
[Fig. 18] Chemical structures of structural units 157 to 165 that are preferable as a substituted triarylamine structural unit represented by the general formula (1) included in a high molecular weight compound used in the present invention.
[Fig. 19] Chemical structures of structural units 1 to 20 that are preferable as a bonding structural unit represented by the general formula (5) included in a high molecular weight compound used in the present invention.
[Fig. 20] Chemical structures of structural units 21 to 32 that are preferable as a bonding structural unit represented by the general formula (5) included in a high molecular weight compound used in the present invention.
[Fig. 21]An example of a layer configuration of an organic EL element according to the present invention.
[Fig. 22] The ¹H-NMR chart of a high molecular weight compound I synthesized in Example 1.
[Fig. 23]The ¹H-NMR chart of a high molecular weight compound II synthesized in Example 2.
[Fig. 24] The ¹H-NMR chart of a high molecular weight compound III synthesized in Example 3.
[Fig. 25] The ¹H-NMR chart of a high molecular weight compound IV synthesized in Example 4.
[Fig. 26] The ¹H-NMR chart of a high molecular weight compound V synthesized in Example 5.
[Fig. 27] The ¹H-NMR chart of a high molecular weight compound VI synthesized in Example 6.
[Fig. 28]The ¹H-NMR chart of a high molecular weight compound VII synthesized in Example 7.
[Fig. 29] The ¹H-NMR chart of a high molecular weight compound VIII synthesized in Example 8.
[Fig. 30]The ¹H-NMR chart of a high molecular weight compound IX synthesized in Example 9.
[Fig. 31] The ¹H-NMR chart of a high molecular weight compound X synthesized in Example 10.
[Fig. 32] The ¹H-NMR chart of a high molecular weight compound XI synthesized in Example 11.

### Description of Embodiments

### 1. High Molecular Weight Compound α

### <Substituted Triarylamine Structural Unit>

A substituted triarylamine structural unit included in a high molecular weight compound α used in the present invention is a divalent group and is represented by a general formula (1) below. Hereinafter, a structural unit represented by the general formula (1) below will be referred to as a "structural unit (1)".

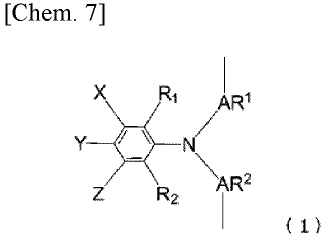

In the general formula (1), AR¹ and AR² each independently represent a divalent aryl or heteroaryl group.

The aromatic ring of the divalent aryl group may be a monocyclic ring or a condensed ring. Examples of such an aromatic ring include a benzene ring, a naphthalene ring, an anthracene ring, a phenanthrene ring, a fluorene ring, an indene ring, a pyrene ring, a perylene ring, a fluorene ring, and the like. These aromatic rings may have a substituent.

The aromatic heterocyclic ring of the divalent heteroaryl group may also be a monocyclic ring or a condensed ring. Examples of such a heterocyclic ring include a pyridine ring, a pyrimidine ring, a triazine ring, a quinoline ring, an isoquinoline ring, a benzofuran ring, a benzothiophene ring, an indole ring, a carbazole ring, a benzoxazole ring, a benzothiazole ring, a quinoxaline ring, a benzimidazole ring, a pyrazoline ring, a dibenzofuran ring, a dibenzothiophene ring, a naphthyridine ring, a phenanthroline ring, an acridine ring, a carboline ring, and the like. These aromatic heterocyclic rings may have a substituent as well.

Examples of the substituent that may be present in the aromatic ring and the aromatic heterocyclic ring above include a heavy hydrogen atom, a cyano group, a nitro group, and the like, and also include the following groups.

Halogen atoms: for example, a fluorine atom, a chlorine atom, a bromine atom, an iodine atom, and the like.

Alkyl groups, in particular those having 1 to 8 carbon atoms: for example, a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, a neooctyl group, and the like.

Alkyloxy groups, in particular those having 1 to 8 carbon atoms: for example, a methyloxy group, an ethyloxy group, a propyloxy group, and the like.

Alkenyl groups: for example, a vinyl group, an allyl group, and the like.

Aryloxy groups: for example, a phenyloxy group, a tolyloxy group, and the like.

Aryl groups: for example, a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, a triphenylenyl group, and the like.

Heteroaryl groups: for example, a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a carbolinyl group, and the like.

Arylvinyl groups: for example, a styryl group, a naphthylvinyl group, and the like.

Acyl groups: for example, an acetyl group, a benzoyl group, and the like.

Moreover, these substituents may further have any of the substituents given as examples above.

Preferably, these substituents are present independently of each other. However, these substituents may be bonded to each other to form a ring via a single bond, a methylene group optionally having a substituent, an oxygen atom, or a sulfur atom.

In the general formula (1), R₁ and R₂ each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms.

Examples of the alkyl group, the cycloalkyl group, the alkenyl group, the alkyloxy group, and the cycloalkyloxy group include the following groups.

Alkyl groups (C₁ to C₈): for example, a methyl group, an ethyl group, an n-propyl group, an isopropyl group, an n-butyl group, an isobutyl group, a tert-butyl group, an n-pentyl group, an isopentyl group, a neopentyl group, an n-hexyl group, an n-octyl group, and the like.

Cycloalkyl groups (C₅ to C₁₀): for example, a cyclopentyl group, a cyclohexyl group, a 1-adamantyl group, a 2-adamantyl group, and the like.

Alkenyl groups (C₂ to C₆): for example, a vinyl group, an allyl group, an isopropenyl group, a 2-butenyl group, and the like.

Alkyloxy groups (C₁ to C₆): for example, a methyloxy group, an ethyloxy group, an n-propyloxy group, an isopropyloxy group, an n-butyloxy group, a tert-butyloxy group, an n-pentyloxy group, an n-hexyloxy group, and the like.

Cycloalkyloxy groups (C₅ to C₁₀): for example, a cyclopentyloxy group, a cyclohexyloxy group, a cycloheptyloxy group, a cyclooctyloxy group, a 1-adamantyloxy group, a 2-adamantyloxy group, and the like.

Moreover, the alkyl group, the cycloalkyl group, the alkenyl group, the alkyloxy group, and the cycloalkyloxy group may also have a substituent. Such substituents are groups that are similar to the substituents that may be present in the aromatic ring and the aromatic heterocyclic ring of the divalent aryl or heteroaryl groups represented by AR¹ and AR², and those are also similar to the substituents that may be present in the aromatic ring and the aromatic heterocyclic ring of the divalent aryl or heteroaryl groups represented by AR¹ and AR² in that these substituents may further have a substituent.

It is desirable that the above-described R₁, R₂, and various substituents are present independently of each other. However, these groups may be bonded to each other to form a ring via a single bond, a methylene group optionally having a substituent, an oxygen atom, or a sulfur atom.

In the general formula (1), X, Y, and Z each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, a cycloalkyloxy group having 5 to 10 carbon atoms, an aryl group, or a heteroaryl group, provided that at least one of X, Y, and Z is an aryl group or a heteroaryl group.

For X, Y, and Z above, examples of the alkyl group, the cycloalkyl group, the alkenyl group, the alkyloxy group, and the cycloalkyloxy group include groups that are similar to those given above as examples with respect to R₁ and R₂. Examples of the aryl group and the heteroaryl group include the following groups.

Aryl groups: a phenyl group, a naphthyl group, an anthracenyl group, a phenanthrenyl group, a triphenylenyl group, a fluorenyl group, an indenyl group, a pyrenyl group, a perylenyl group, a fluoranthenyl group, and the like.

Heteroaryl groups: a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, a carbolinyl group, and the like.

Moreover, the aryl group and the heteroaryl group above may have a substituent. Such substituents are also groups that are similar to the substituents that may be present in the aromatic ring and the aromatic heterocyclic ring of the divalent aryl or heteroaryl groups represented by AR¹ and AR², and those are also similar to the substituents that may be present in the aromatic ring and the aromatic heterocyclic ring of the divalent aryl or heteroaryl groups represented by AR¹ and AR² in that these substituents may further have a substituent.

For example, the aryl group and the heteroaryl group above may have a phenyl group as a substituent, and this phenyl group may further have a phenyl group as a substituent. More specifically, in the case where the aryl group is a phenyl group, this aryl group may be a biphenylyl group or a terphenylyl group.

Furthermore, it is desirable that the above-described aryl group, heteroaryl group, and various substituents are present independently of each other. However, these groups may be bonded to each other to form a ring via a single bond, a methylene group optionally having a substituent, an oxygen atom, or a sulfur atom.

In the present invention, AR¹ and AR² above are preferably phenylene groups, biphenylene groups, naphthylene groups, phenanthrenylene groups, dibenzofuranylene groups, dibenzothienylene groups, or fluorenylene groups having a substituent, and are most preferably unsubstituted phenylene groups in terms of synthesis. Note that, as the substituent of the fluorenylene groups, a methyl group, an ethyl group, an n-propyl group, an n-butyl group, an n-pentyl group, an n-hexyl group, an n-heptyl group, an n-octyl group, and a phenyl group are preferable.

In the present invention, R₁ and R₂ above are preferably hydrogen atoms or heavy hydrogen atoms, and hydrogen atoms are most preferably in terms of synthesis.

In the present invention, it is preferable that two or more of X, Y, and Z are preferably aryl groups optionally having a substituent or heteroaryl groups optionally having a substituent, and it is more preferable that X and Y are aryl groups optionally having a substituent, and Z is a hydrogen atom. X is even more preferably an aryl group having no substituent, and most preferably a phenyl group. Y is even more preferably an aryl group having a substituent, particularly preferably a phenyl group having an aryl group as a substituent, and most preferably a naphtylphenyl group. When X, Y, and Z are such groups, a high molecular weight compound α having excellent hole injectability, hole mobility, electron blockability, and the like can be obtained.

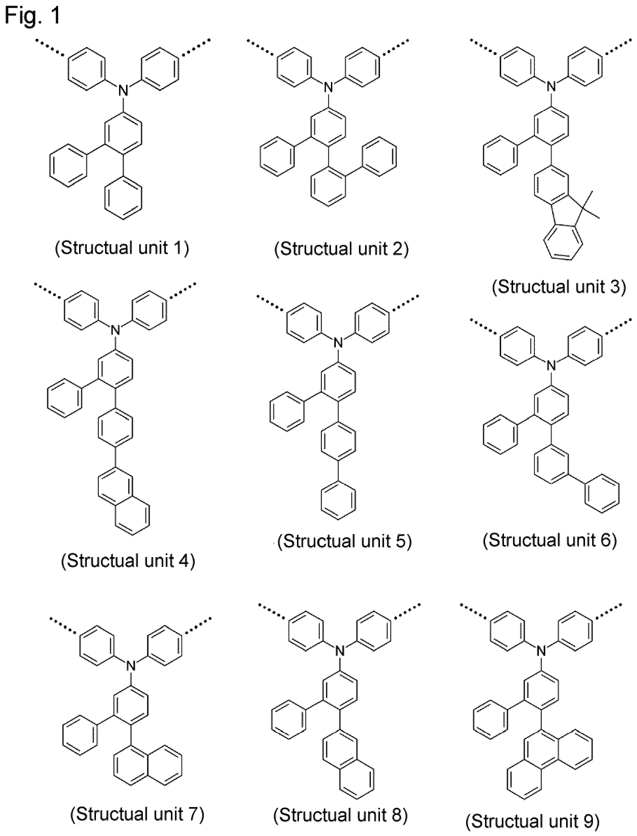

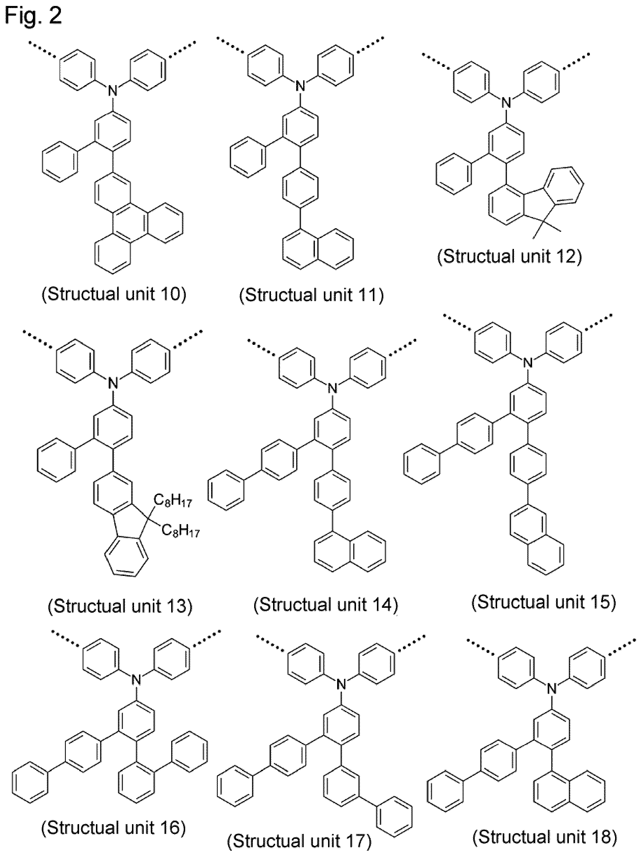

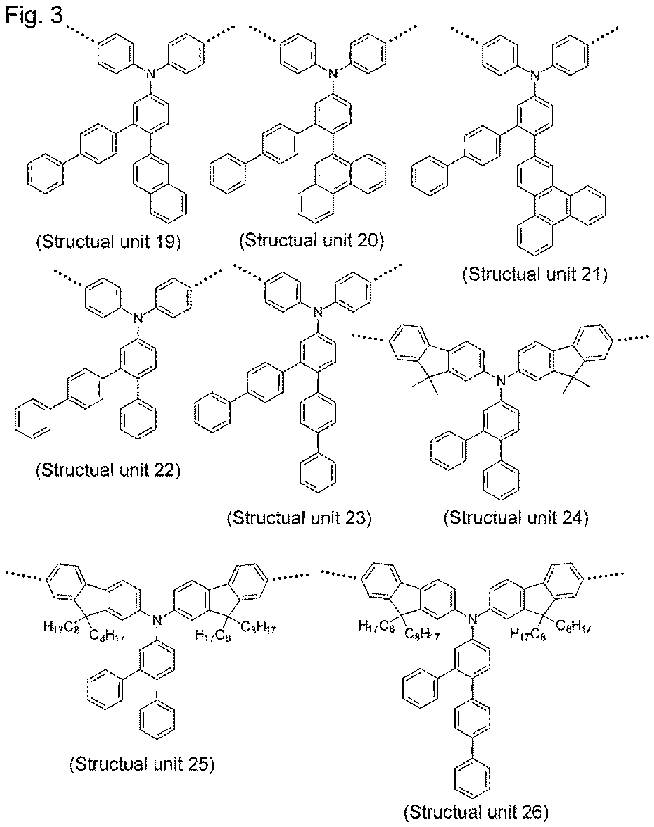

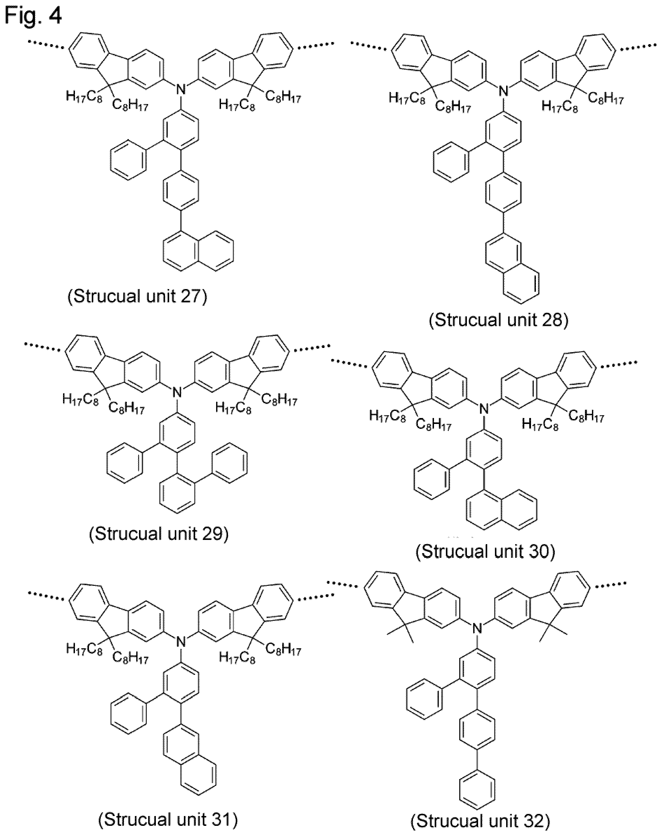

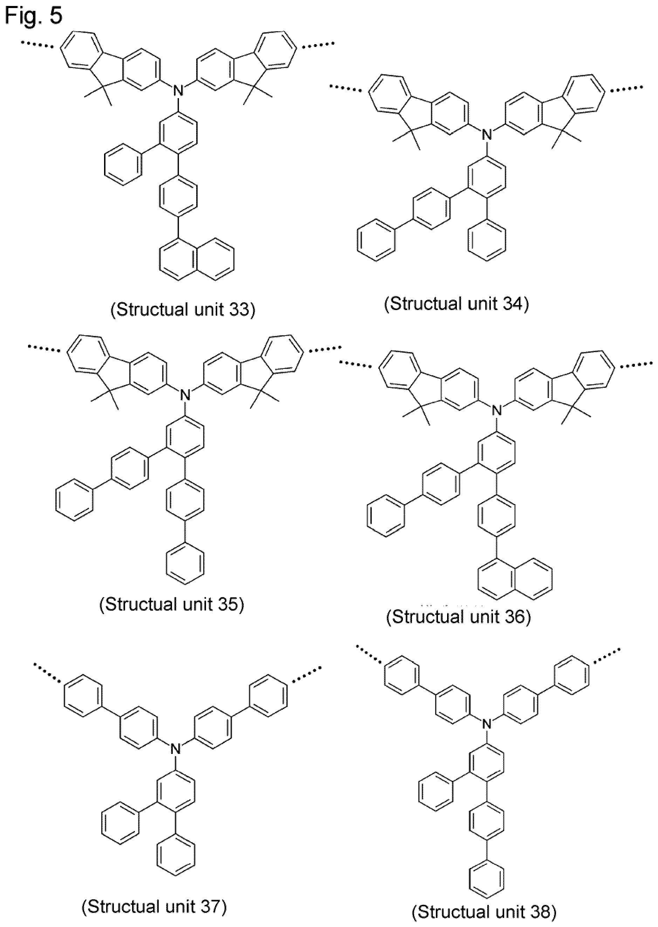

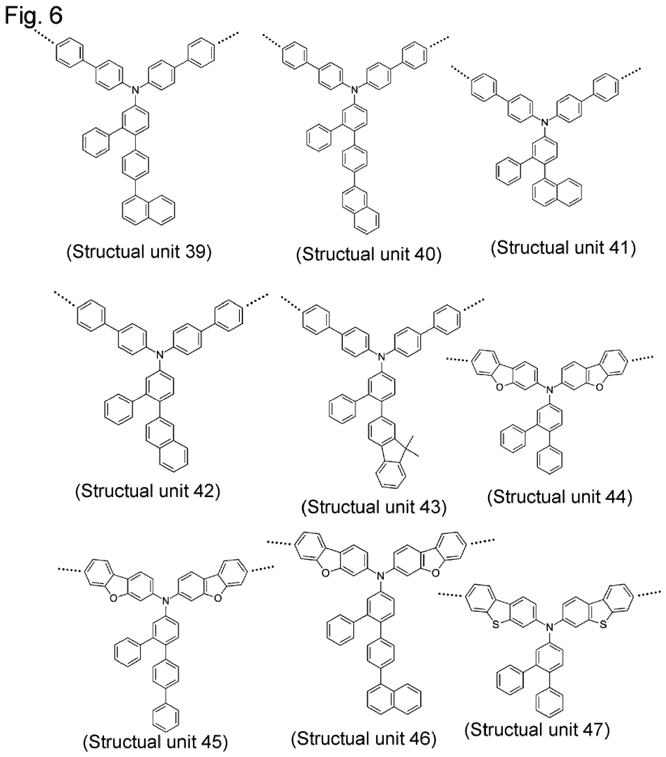

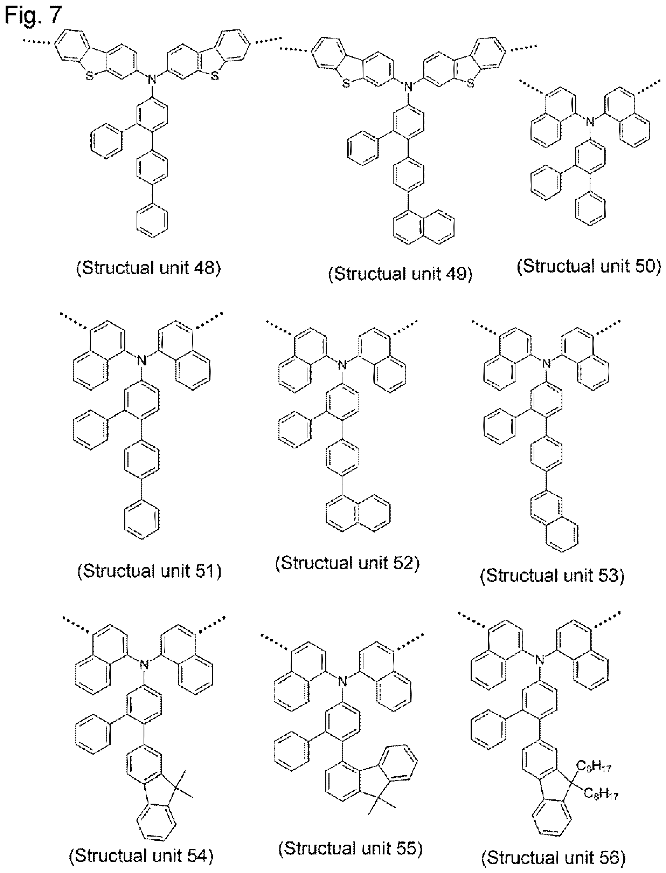

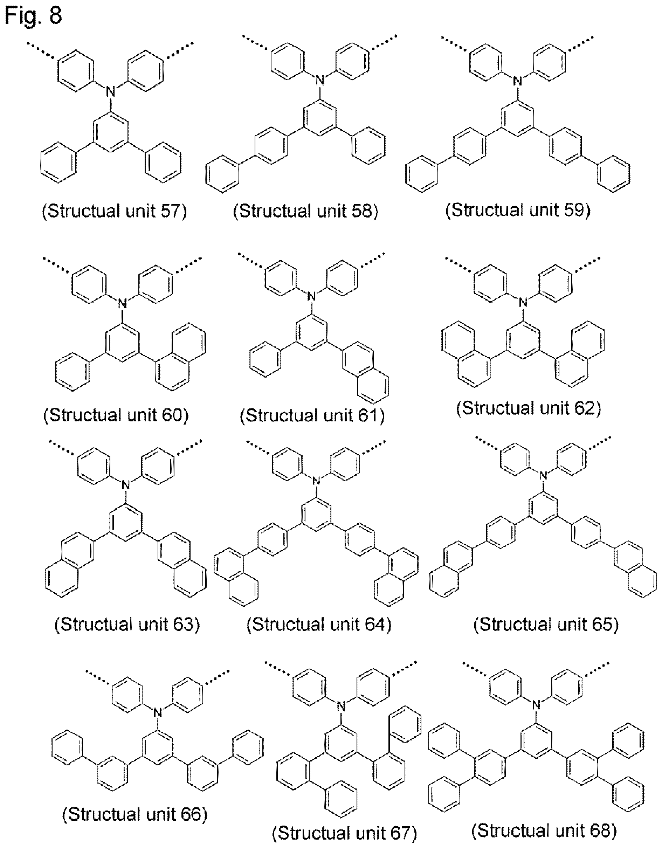

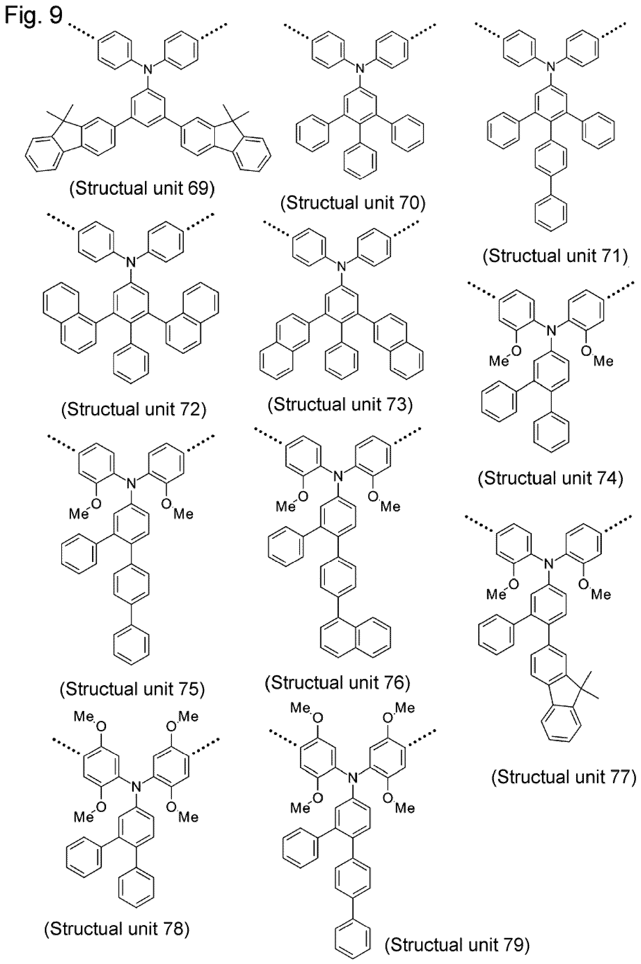

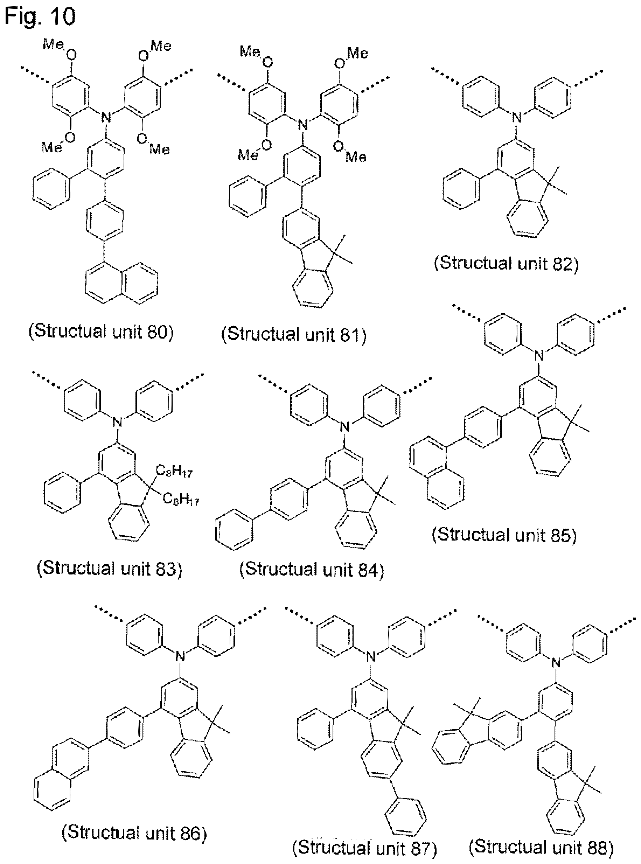

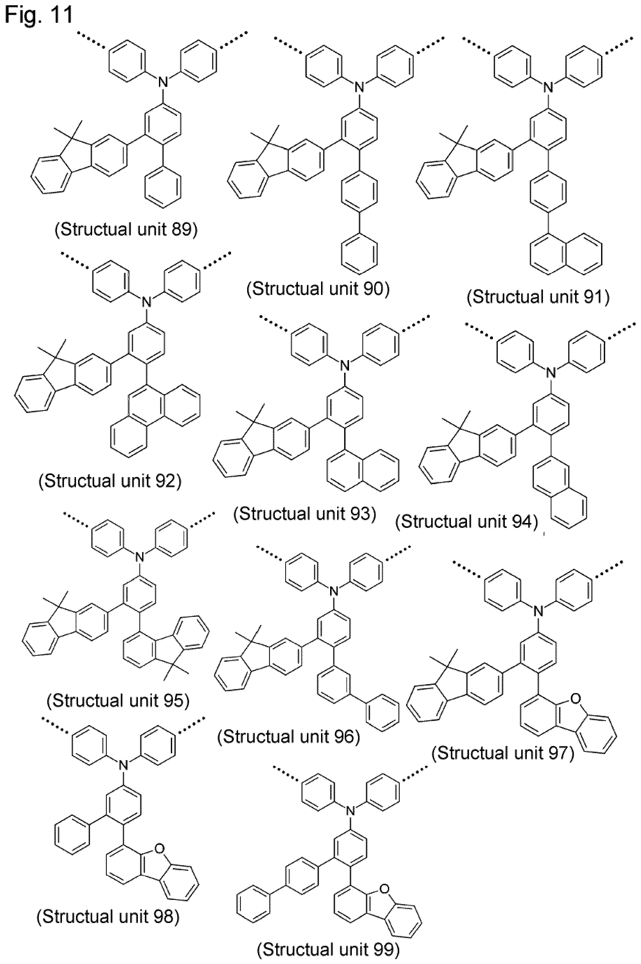

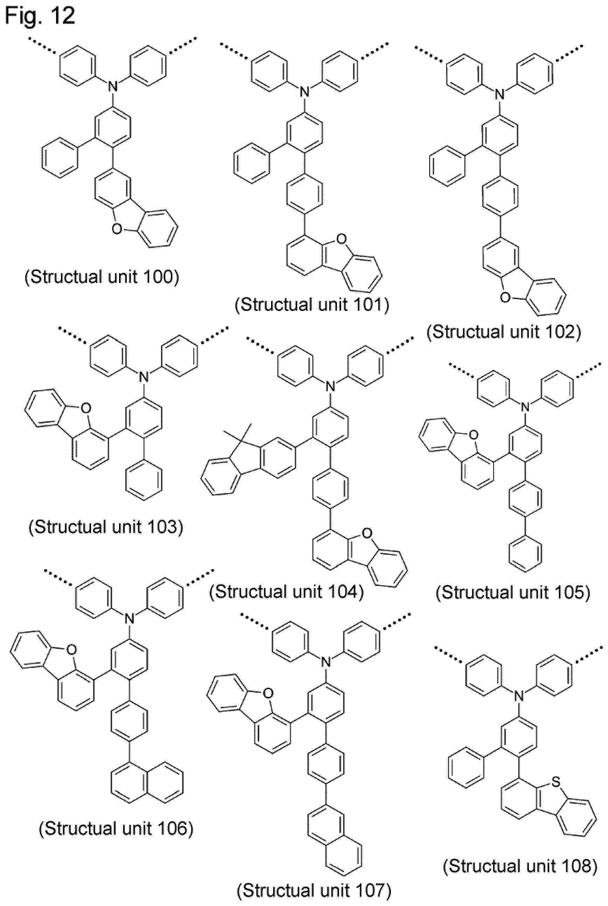

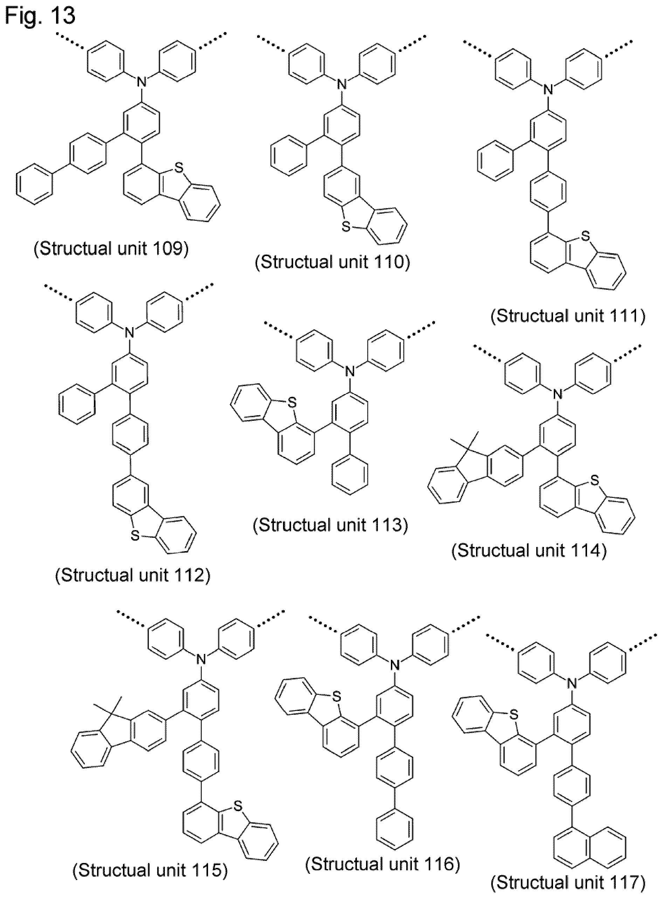

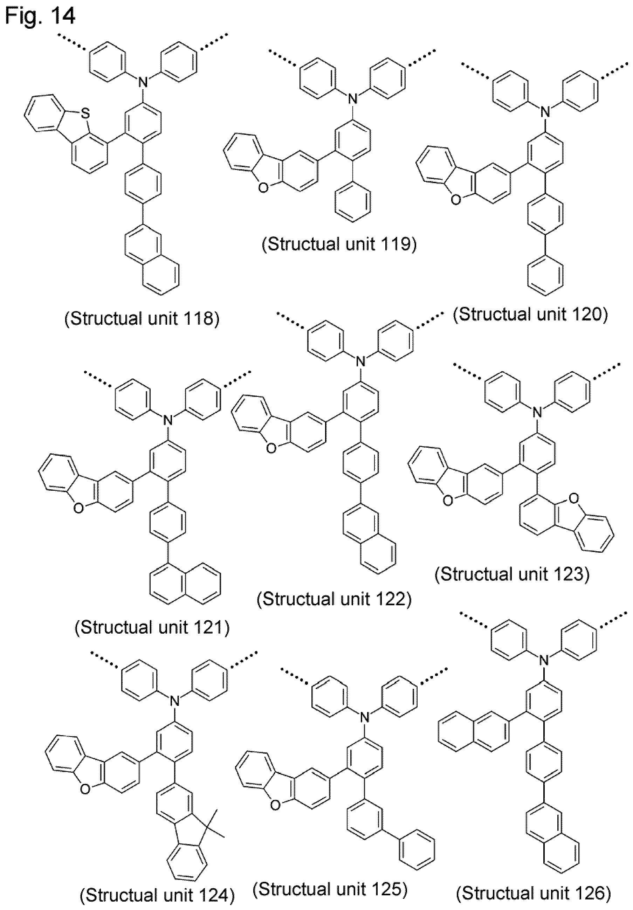

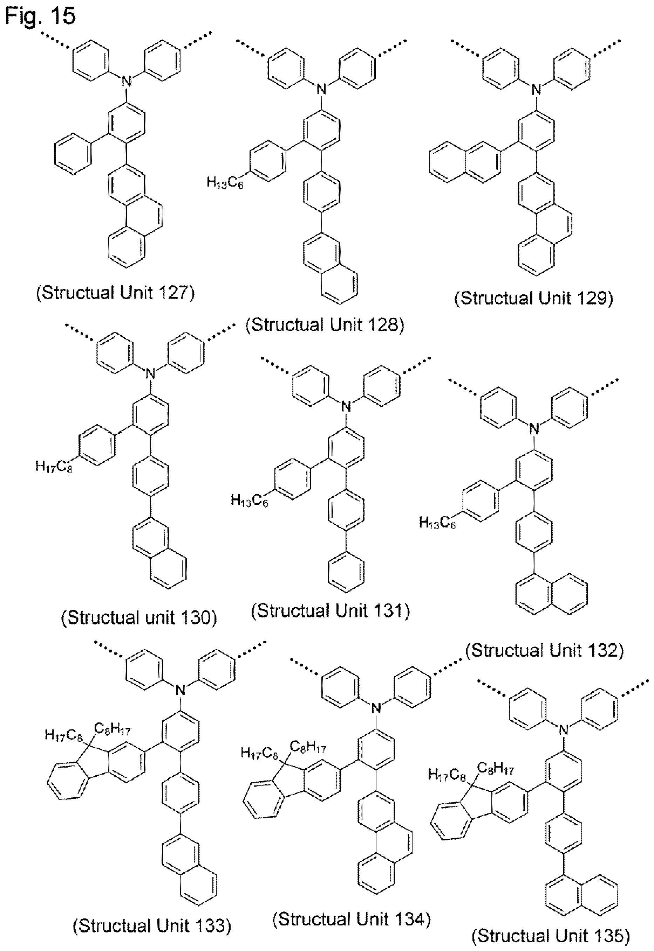

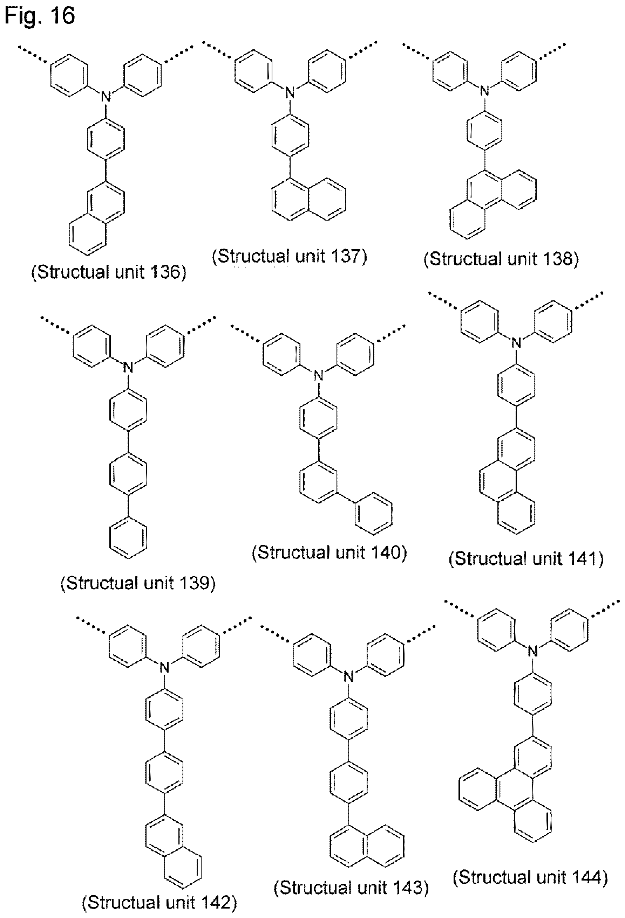

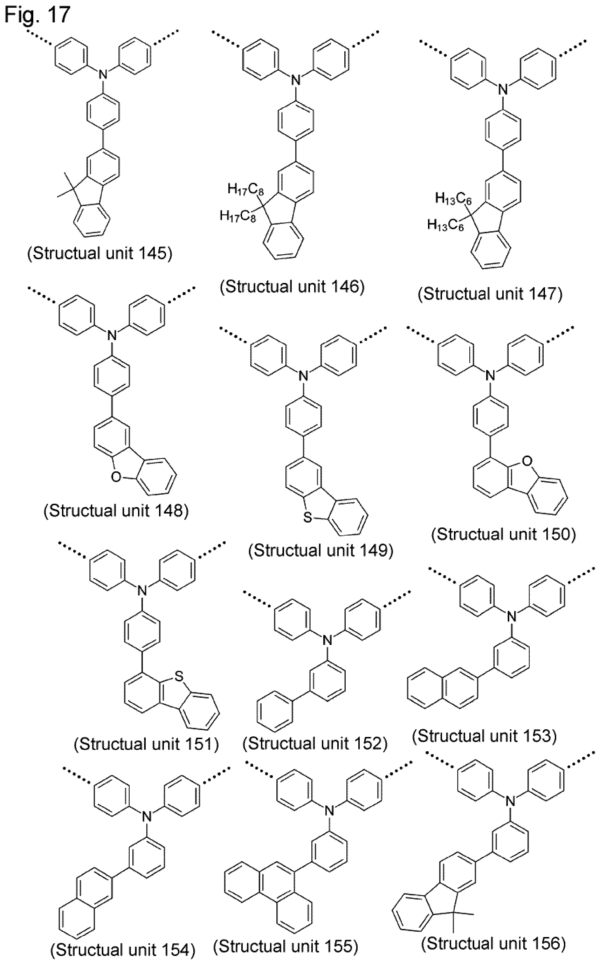

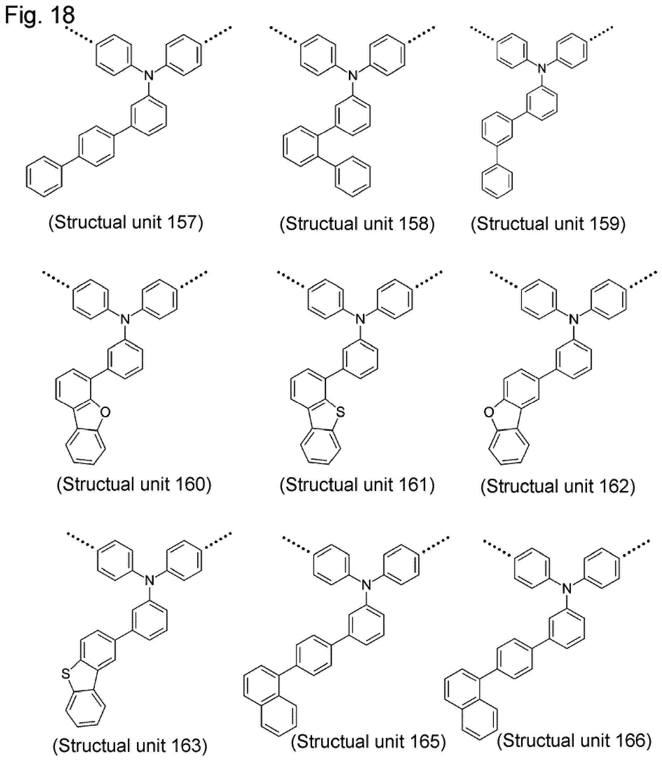

Preferred specific examples of the above-described structural unit (1), which is a structural unit of the high molecular weight compound α used in the present invention, are shown as structural units 1 to 165 in Figs. 1 to 18, although the structural unit (1) included in the high molecular weight compound α used in the present invention is not limited to these structural units.

Note that, in the chemical formulae shown in Figs. 1 to 18, each dotted line indicates a bond to an adjacent structural unit, and each solid line extending from a ring indicates substitution by a methyl group.

### <Structural Unit Having Aromatic Hydrocarbon Ring>

The high molecular weight compound α used in the present invention may have a structural unit (hereinafter referred to as a "structural unit (2)") having an aromatic hydrocarbon ring other than the above-described structural unit (1). Examples of the structural unit (2) include structural units represented by general formulae (2a) to (2x) below.

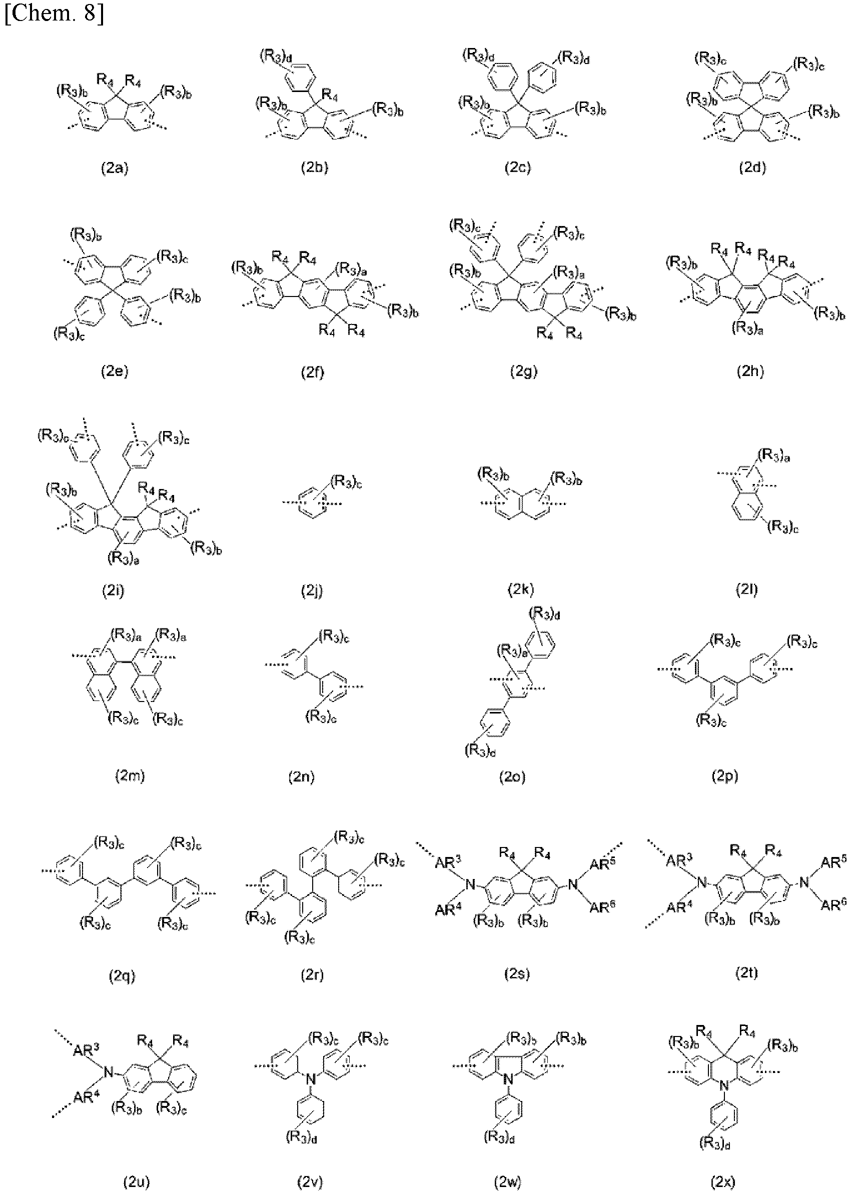

In the above formulae, R₃ each independently represent a heavy hydrogen atom, a cyano group, a nitro group, a fluorine atom, a chlorine atom, a bromine atom, or an iodine atom, or an alkyl, cycloalkyl, alkyloxy, cycloalkyloxy, thioalkyloxy, alkenyl, or aryloxy group having not more than 40 (in particular, 3 to 40) carbon atoms,
R₄ represents an alkyl, cycloalkyl, alkyloxy, thioalkyloxy, or cycloalkyloxy group having not more than 40 (in particular, 3 to 40) carbon atoms,
AR³ to AR⁶ each independently represent a monovalent or divalent aryl or heteroaryl group,
a to d are the number of R₃, and each independently represent an integer below:
   a = 0, 1, or 2,
   b = 0, 1, 2, or 3,
   c = 0, 1, 2, 3, or 4, and
   d = 0, 1, 2, 3, 4, or 5.

Examples of the alkyl group, the cycloalkyl group, the alkyloxy group, the cycloalkyloxy group, and the alkenyl group can be groups that are similar to the groups given above as examples with respect to R₁ and R₂ above. Examples of the aryloxy group can be groups that are similar to the groups given above as examples of the substituent that may be present in AR¹ and AR². Examples of the aryl group and the heteroaryl group can be groups that are similar to the groups given above as examples with respect to AR¹ and AR².

Examples of the thioalkyloxy group include a thiomethyloxy group, a thioethyloxy group, a thio-n-propyloxy group, a thioisopropyloxy group, a thio-n-butyloxy group, a thio-tert-butyloxy group, a thio-n-pentyloxy group, a thio-n-hexyloxy group, a thio-n-heptyloxy group, a thio-n-octyloxy group, and the like.

In the present invention, in terms of solubility and thin film stability, it is preferable that the high molecular weight compound α has, as the structural unit (2), at least one structural unit selected from the structural units represented by the general formulae (2a) to (2x), and more preferably at least one structural unit selected from the general formulae (2a) and (2v). In the general formula (2a), it is preferable that b is 0 and R₄ is an alkyl group having 3 to 40 carbon atoms, and it is more preferable that b is 0 and R₄ is an alkyl group having 4 to 10 carbon atoms. In the general formula (2v), it is preferable that c and d are 0.

### <Thermal Crosslinkable Structural Unit>

The high molecular weight compound α used in the present invention may have a thermal crosslinkable structural unit (hereinafter referred to as a "structural unit (3)"). Examples of the structural unit (3) include structural units represented by general formulae (3a) to (3z) below.

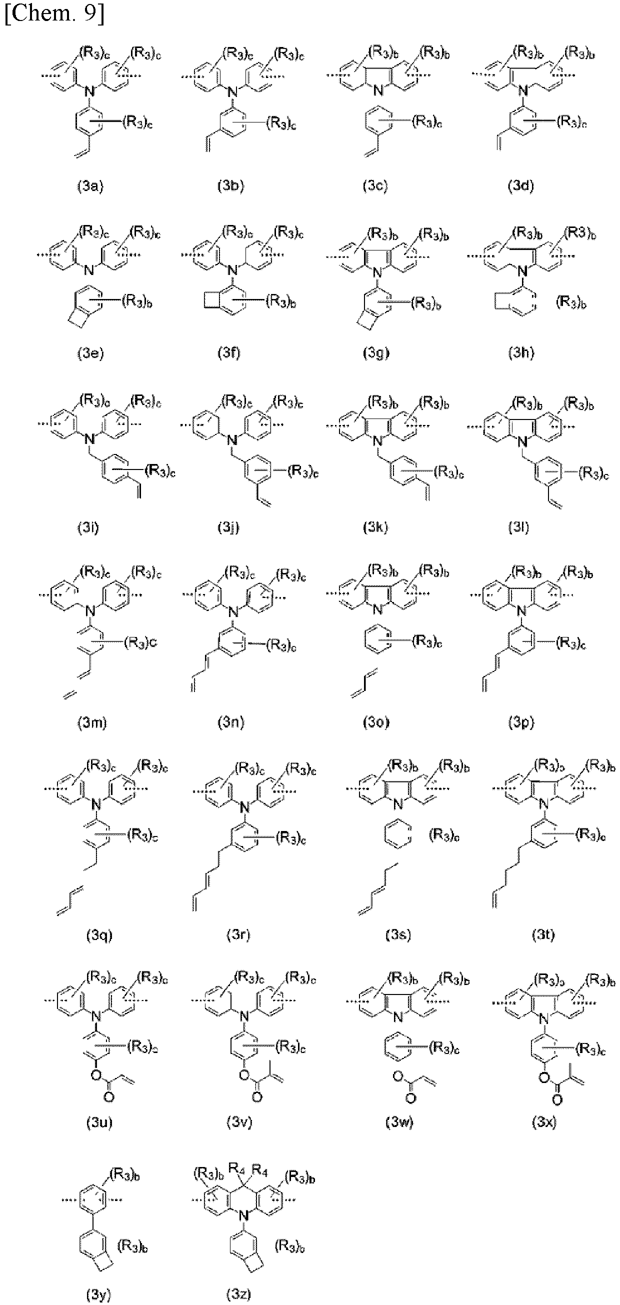

In the above formulae, R₃, R₄, and a to c are as defined in the general formulae (2a) to (2x).

In the present invention, in terms of heat resistance, it is preferable that the high molecular weight compound α has, as the structural unit (3), at least one structural unit selected from the structural units represented by the general formulae (3a) to (3z), and more preferably at least one structural unit selected from the general formulae (3e), (3f), and (3y). In the general formulae (3e) and (3f), it is preferable that b and c are 0. In the general formula (3y), it is preferable that b is 0.

In the present invention, it is preferable that, with respect to all the structural units constituting the high molecular weight compound α, the structural unit (1) is contained in a proportion of 30 to 60 mol%, the structural unit (2) is contained in a proportion of 40 to 70 mol%, and the structural unit (3) is contained in a proportion of 0 to 20 mol%. When these structural units are contained in such proportions, a high molecular weight compound α having excellent hole injectability, hole mobility, electron block ability, and the like can be obtained.

### 2. High Molecular Weight Compound β

### <Triarylamine Structural Unit and Bonding Structural Unit>

Both of a triarylamine structural unit and a bonding structural unit included in the high molecular weight compound β used in the present invention are divalent groups, and are respectively represented by general formulae (4) and (5) below. Hereinafter, a triarylamine structural unit represented by the general formula (4) below will be referred to as a "structural unit (4)", and a bonding structural unit represented by the general formula (5) below will be referred to as a "structural unit (5)".

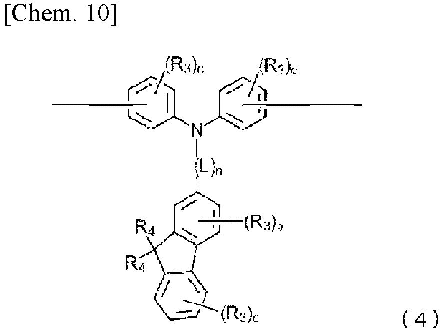

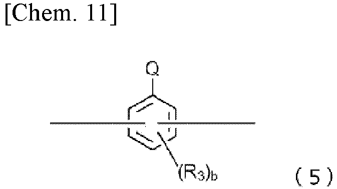

In the general formulae (4) and (5), R₃ represents a heavy hydrogen atom, a cyano group, a nitro group, a fluorine atom, a chlorine atom, a bromine atom, an iodine atom, an alkyl or alkyloxy group having 1 to 8 carbon atoms, a cycloalkyl or cycloalkyloxy group having 5 to 10 carbon atoms, an alkenyl group having 2 to 6 carbon atoms, or an aryloxy group.

Examples of the alkyl group, the alkyloxy group, the cycloalkyl group, the cycloalkyloxy group, the alkenyl group, and the aryloxy group include the following groups.

Alkyl groups (having 1 to 8 carbon atoms): for example, a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, a neooctyl group, and the like.

Alkyloxy groups (having 1 to 8 carbon atoms): for example, a methyloxy group, an ethyloxy group, an n-propyloxy group, an isopropyloxy group, an n-butyloxy group, a tert-butyloxy group, an n-pentyloxy group, an n-hexyloxy group, an n-heptyloxy group, an n-octyloxy group, and the like.

Cycloalkyl groups (having 5 to 10 carbon atoms): for example, a cyclopentyl group, a cyclohexyl group, a 1-adamantyl group, a 2-adamantyl group, and the like.

Cycloalkyloxy groups (having 5 to 10 carbon atoms): for example, a cyclopentyloxy group, a cyclohexyloxy group, a cycloheptyloxy group, a cyclooctyloxy group, a 1-adamantyloxy group, a 2-adamantyloxy group, and the like.

Alkenyl groups (having 2 to 6 carbon atoms): for example, a vinyl group, an allyl group, an isopropenyl group, a 2-butenyl group, and the like.

Aryloxy groups: for example, a phenyloxy group, a tolyloxy group, and the like.

In the general formula (4), R₄ represents an alkyl or alkyloxy group having 1 to 8 carbon atoms or a cycloalkyl or cycloalkyloxy group having 5 to 10 carbon atoms.

Examples of the alkyl group, the alkyloxy group, the cycloalkyl group, and the cycloalkyloxy group can be groups that are similar to the groups given above as examples with respect to R₃.

In the general formulae (4) and (5), b and c are the numbers of R₃, and each independently represent an integer below:
b = 0, 1, 2, or 3, and
c = 0, 1, 2, 3, or 4.

In the general formula (5), Q represents a hydrogen atom, a heavy hydrogen atom, an amino group, a monovalent aryl group, or a monovalent heteroaryl group.

Examples of the monovalent aryl group and the monovalent heteroaryl group include the following groups.

Aryl groups: for example, a phenyl group, a naphthyl group, an anthracenyl group, a phenanthrenyl group, a fluorenyl group, an indenyl group, a pyrenyl group, a perylenyl group, a fluoranthenyl group, and the like.

Heteroaryl groups: for example, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, an indenocarbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, a carbolinyl group, and the like.

Moreover, the amino group, the monovalent aryl group, and the monovalent heteroaryl group above may have a substituent. Examples of the substituent include a heavy hydrogen atom, a cyano group, a nitro group, and the like, and also include the following groups.

Halogen atoms: for example, a fluorine atom, a chlorine atom, a bromine atom, an iodine atom, and the like.

Alkyl groups, in particular those having 1 to 8 carbon atoms: for example, a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, a neooctyl group, and the like.

Alkyloxy groups, in particular those having 1 to 8 carbon atoms: for example, a methyloxy group, an ethyloxy group, a propyloxy group, and the like.

Alkenyl groups: for example, a vinyl group, an allyl group, and the like.

Aryloxy groups: for example, a phenyloxy group, a tolyloxy group, and the like.

Aryl groups: for example, a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, a triphenylenyl group, and the like.

Heteroaryl groups: for example, a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, an indenocarbazolyl group, a benzoxazolyl group, a benzothiazolyl group, a quinoxalinyl group, a benzimidazolyl group, a pyrazolyl group, a dibenzofuranyl group, a dibenzothienyl group, a carbolinyl group, and the like.

Arylvinyl groups: for example, a styryl group, a naphthylvinyl group, and the like.

Acyl groups: for example, an acetyl group, a benzoyl group, and the like.

Moreover, these substituents may further have any of the substituents given as examples above.

Preferably, these substituents are present independently of each other. However, these substituents may be bonded to each other to form a ring via a single bond, a methylene group optionally having a substituent, an oxygen atom, or a sulfur atom.

For example, the aryl group and the heteroaryl group above may have a phenyl group as a substituent, and this phenyl group may further have a phenyl group as a substituent. More specifically, in the case where the aryl group is a phenyl group, this aryl group may be a biphenylyl group, a terphenylyl group, or a triphenylenyl group.

In the general formula (4), L represents a divalent phenyl group, and n represents an integer of 0 to 3.

Furthermore, L above may have a substituent. Examples of the substituent include groups that are similar to the substituents that may be present in the amino group, the monovalent aryl group, and the monovalent heteroaryl group represented by Q above, and these substituents may further have a substituent.

In the general formula (4), when neither b nor c is 0, it is preferable that R₃ is a heavy hydrogen atom, and, in terms of synthesis, it is most preferable that b and c are 0, or in other words, R₃ is not present. Also, in the general formula (5), when b is not 0, it is preferable that R₃ is a heavy hydrogen atom, and, in terms of synthesis, it is most preferable that b is 0, or in other words, R₃ is not present.

In the high molecular weight compound β used in the present invention, R₄ above is most preferably an n-hexyl group or an n-octyl group in order to enhance solubility.

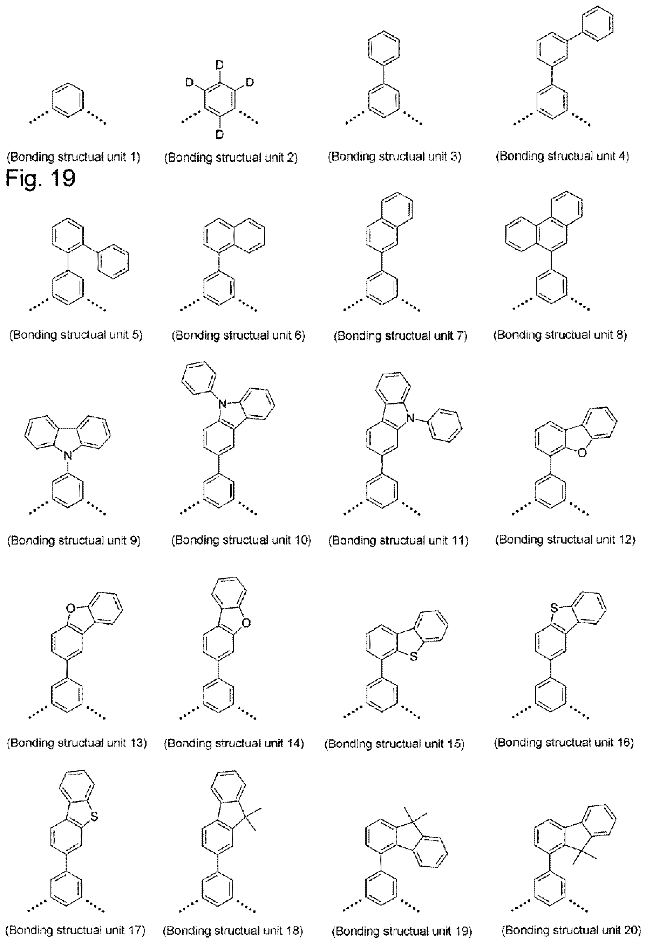

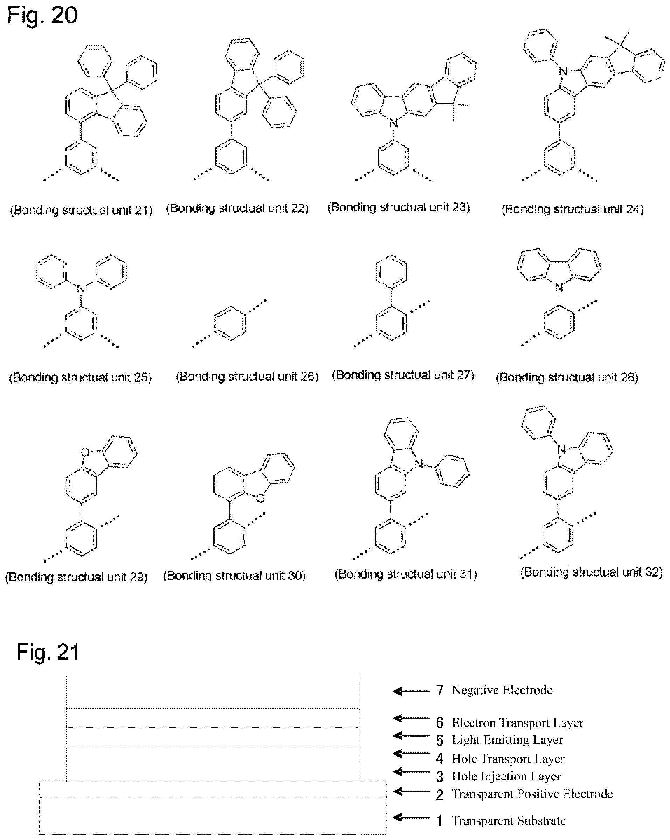

Preferred specific examples of the above-described structural unit (5) used in the present invention are shown as bonding structural units 1 to 32 in Figs. 19 and 20, although the structural unit (5) included in the high molecular weight compound β used in the present invention is not limited to these structural units.

Note that, in the chemical formulae shown in Figs. 19 and 20, each dotted line indicates a bond to an adjacent structural unit, and each solid line extending from a ring indicates substitution by a methyl group.

In the present invention, in terms of synthesis, it is preferable that the structural unit (5) included in the high molecular weight compound β is the bonding structural unit 1 in Fig. 19, that is, a 1,3-phenylene group.

The high molecular weight compound β used in the present invention may have a structural unit (3). The structural unit (3) is as described above in the description of the high molecular weight compound α. Preferred structural units in the high molecular weight compound β are the same as the preferred structural units in the high molecular weight compound α.

In the present invention, it is preferable that, with respect to all the structural units constituting the high molecular weight compound β, the structural unit (4) is contained in a proportion of 30 to 60 mol%, the structural unit (5) is contained in a proportion of 40 to 70 mol%, and the structural unit (3) is contained in a proportion of 0 to 20 mol%. When these structural units are contained in such proportions, a high molecular weight compound β having excellent hole injectability, hole mobility, electron block ability, and the like can be obtained.

### 3. Methods for Producing High Molecular Weight Compounds

### <High Molecular Weight Compound α>

As already described above, the high molecular weight compound α used in the present invention has excellent characteristics such as hole injectability, hole mobility, electron block ability, thin film stability, and heat resistance. The high molecular weight compound α has a weight average molecular weight within a range of preferably 10,000 or more and less than 1,000,000, more preferably 10,000 or more and less than 500,000, and even more preferably 10,000 or more and less than 200,000 in terms of polystyrene when measured using GPC.

The high molecular weight compound α used in the present invention can be synthesized by forming C-C bonds or C-N bonds through a Suzuki polymerization reaction or a HARTWIG-BUCHWALD polymerization reaction so as to connect the structural units. Preferably, the high molecular weight compound α used in the present invention can be synthesized by preparing unit compounds that respectively have the above-described structural units and subjecting the unit compounds to boric acid esterification or halogenation as appropriate and then subjecting the resulting borate ester(s) and halide(s) to a polycondensation reaction using an appropriate catalyst.

For example, a triarylamine derivative represented by a general formula (1a) below can be used as a compound for introducing a structural unit represented by the general formula (1). 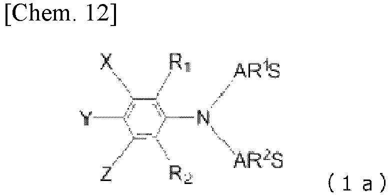 In the above formula, S represents a hydrogen atom, a halogen atom (Br is particularly preferable), or a borate ester group, and all of AR¹, AR², X, Y, Z, R₁, and R₂ are the same as those in the general formula (1).

That is to say, the general formula (1a) above represents a unit compound for introducing a structural unit represented by the general formula (1) when S is a hydrogen atom, a halide used for the polymer synthesis when S is a halogen atom, or a borate ester used for the polymer synthesis when S is a borate ester group.

For example, a terpolymer having a structural unit (structural unit A) represented by the general formula (1) in an amount of 40 mol%, a structural unit (structural unit B) represented by the general formula (2a) in an amount of 50 mol%, and a structural unit (structural unit C) represented by the general formula (3e) in an amount of 10 mol% is represented by a general formula (7) below.

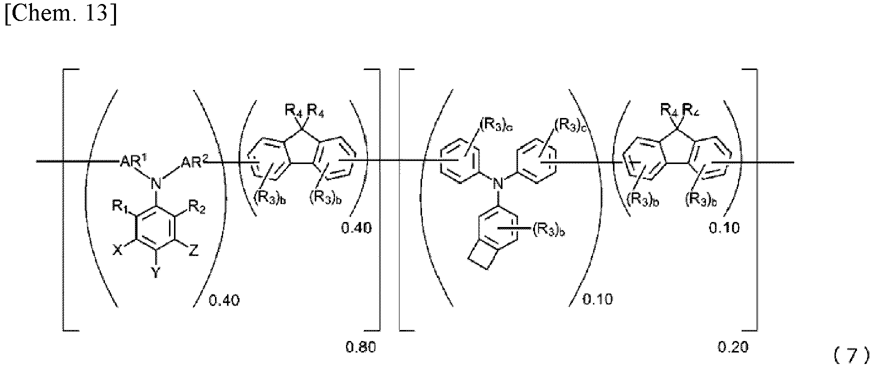

In this case, halides are used as intermediates for introducing the structural unit A and the structural unit C, while a borate ester is used as an intermediate for introducing the structural unit B. Alternatively, borate esters are used as intermediates for introducing the structural unit A and the structural unit C, while a halide is used as an intermediate for introducing the structural unit B. That is to say, in order to obtain a high molecular weight compound α having a high molecular weight, the halide(s) and the borate ester(s) need to be contained in an equal molar ratio, and the molecular weight of a high molecular weight compound α to be obtained can be controlled by adjusting the molar ratio.

### <High Molecular Weight Compound β>

As already described above, the high molecular weight compound β used in the present invention has characteristics similar to the characteristics of the high molecular weight compound α described above, and further has the characteristics of having a wide bandgap. The high molecular weight compound β has a weight average molecular weight within a range of preferably 10,000 or more and less than 1,000,000, more preferably 10,000 or more and less than 500,000, and even more preferably 10,000 or more and less than 200,000 in terms of polystyrene when measured using GPC.

The high molecular weight compound β used in the present invention can be synthesized in a manner similar to that used in synthesizing the high molecular weight compound α described above.

For example, a terpolymer having a structural unit (structural unit D) represented by the general formula (4) in an amount of 40 mol%, a structural unit (structural unit E) represented by the general formula (5) in an amount of 50 mol%, and a structural unit (structural unit C) represented by the general formula (3e) in an amount of 10 mol% is represented by a general formula (8) below.

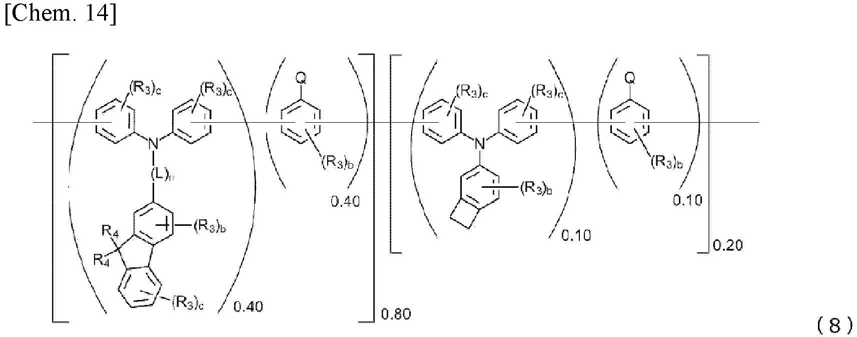

In this case, borate esters are used as intermediates for introducing the structural unit D and the structural unit C, while a halide is used as an intermediate for introducing the structural unit E. Alternatively, halides are used as intermediates for introducing the structural unit D and the structural unit C, while a borate ester is used as an intermediate for introducing the structural unit E. That is to say, in order to obtain a high molecular weight compound β having a high molecular weight, the halide(s) and the borate ester(s) need to be contained in an equal molar ratio, and the molecular weight of the high molecular weight compound β to be obtained can be controlled by adjusting the molar ratio.

### 4. Mixed Coating Solution

With the above-described high molecular weight compounds α and β used in the present invention, a thin film having excellent characteristics such as hole injectability, hole transportability, and electron blockability can be formed by applying a mixed coating solution prepared by dissolving the high molecular weight compounds α and β in an aromatic organic solvent, such as benzene, toluene, xylene, or anisole, to a predetermined substrate to form a coating, and then heating and drying the coating. The thin film that is formed in this manner also has good heat resistance, and further has good adhesion to other layers. The mixed coating solution may also contain other high molecular weight compounds, in addition to the high molecular weight compounds α and β.

The usage ratio between the high molecular weight compounds α and β is preferably 1:5 to 5:1 by mass, and more preferably 1:3 to 3:1 by mass. If the usage ratio is outside this range, the effect of using two or more high molecular weight compounds to obtain an organic EL element having a longer lifespan than when a single high molecular weight compound is used is less likely to be achieved.

For example, the high molecular weight compounds α and β can be used as constituent materials of a hole injection layer and/or a hole transport layer of an organic EL element. The hole injection layer or the hole transport layer made of the mixed coating solution containing the high molecular weight compounds α and β can achieve advantages of improving the durability of the organic EL element, compared with a hole injection layer or a hole transport layer made of a conventional material alone.

In addition, the mixed coating solution can also be suitably used to form an electron blocking layer or a light emitting layer.

### 5. Organic EL Element

An organic EL element that includes an organic layer formed using the above-described mixed coating solution has, for example, a structure shown in Fig. 21. Specifically, the organic EL element has a structure in which a transparent positive electrode 2, a hole injection layer 3, a hole transport layer 4, a light emitting layer 5, an electron transport layer 6, and a negative electrode 7 are provided on a transparent substrate 1, which can be a glass substrate, a transparent resin substrate, or any other substrate made of a transparent material.

The organic EL element of the present invention is not limited to the above-described layer structure. A hole blocking layer may be provided between the light emitting layer 5 and the electron transport layer 6. An electron blocking layer or the like may be provided between the hole transport layer 4 and the light emitting layer 5. Also, an electron injection layer may be provided between the negative electrode 7 and the electron transport layer 6. Furthermore, some of the layers may be omitted. For example, the organic EL element may have a simple layer structure in which a transparent positive electrode 2, a hole transport layer 4, a light emitting layer 5, an electron transport layer 6, and a negative electrode 7 are provided on a transparent substrate 1. Moreover, each of the layers may have a double-layer structure in which layers having the same function are laid one on top of the other.

The mixed coating solution is suitably used to form an organic layer that is provided between the transparent positive electrode 2 and the negative electrode 7, for example, the hole injection layer 3, the hole transport layer 4, the light emitting layer 5, or an electron blocking layer, which is not shown, because of the characteristics, such as the hole injectability and the hole transportability, of a thin film that can be obtained using the mixed coating solution.

In the above-described organic EL element, the transparent positive electrode 2 can be formed using an electrode material that itself is known, and is formed by depositing an electrode material that has a large work function, such as ITO or gold, on the transparent substrate 1.

The hole injection layer 3 provided on the transparent positive electrode 2 can be formed using the mixed coating solution. Specifically, the hole injection layer 3 can be formed by applying the mixed coating solution to the transparent positive electrode 2 through spin coating, inkjet printing, or the like to form a coating thereon.

Furthermore, the hole injection layer 3 can also be formed using a conventionally known material, examples of which includes:
a porphyrin compound as typified by copper phthalocyanine; a star burst triphenylamine derivative; an arylamine having a structure in which molecules are connected via a single bond or a divalent group that does not have a hetero atom, for example, a triphenylamine trimer or tetramer; an acceptor-like heterocyclic ring compound such as hexacyanoazatriphenylene; and a coating polymer material such as, for example, poly(3,4-ethylenedioxythiophene) (PEDOT) or poly(styrenesulfonate) (PSS).

The formation of a layer (thin film) using such a material can be performed using a deposition method as well as a coating method such as spin coating, inkjet printing, or the like. The same applies to the other layers, and film formation is performed using a deposition method or a coating method according to the type of the film-forming material.

As with the hole injection layer 3, the hole transport layer 4 provided on the hole injection layer 3 can also be formed using a coating method, such as spin coating or inkjet printing, using the mixed coating solution.

Furthermore, the hole transport layer 4 can also be formed using a conventionally known hole transport material. Typical examples of the hole transport material include:
benzidine derivatives such as N,N'-diphenyl-N,N'-di(m-tolyl)benzidine (TPD), N,N'-diphenyl-N,N'-di(α-naphthyl)benzidine (NPD), and N,N,N',N'-tetrabiphenylyl benzidine; amine derivatives such as 1,1-bis[4-(di-4-tolylamino)phenyl]cyclohexane (TAPC); various types of triphenylamine trimers and tetramers; coating polymer materials that are also used to form a hole injection layer; and the like.

Although each of the above-described materials, including the above-described high molecular weight compounds α and β, used to form the hole transport layer 4 may be used alone to form the layer, it is also possible to use a mixture of two or more of the materials to form the layer. Alternatively, a multi-layer film in which a plurality of layers formed using one or more of the materials are stacked may be used as the hole transport layer.

Furthermore, it is also possible to form a layer that serves as both the hole injection layer 3 and the hole transport layer 4. Such a hole injection and transport layer can be formed using a coating method with use of a polymer material such as PEDOT.

To form the hole injection layer 3 and the hole transport layer 4, a material obtained by p-doping a material usually used to form these layers with trisbromophenylamine hexachloroantimony, a radialene derivative (see WO 2014/009310, for example), or the like can be used. In addition, a polymer compound having a TPD basic skeleton, or the like can also be used.

Furthermore, although not shown, an electron blocking layer that may be provided between the hole transport layer 4 and the light emitting layer 5 can be formed using a coating method, such as spin coating or inkjet printing, using the mixed coating solution, as is the case with the hole transport layer 4.

In addition, the electron blocking layer can also be formed using a known electron blocking compound that has an electron blocking effect, such as, for example, a carbazole derivative or a compound that has a triphenylsilyl group and a triarylamine structure. Specific examples of the carbazole derivative and the compound that has a triarylamine structure are as follows:
carbazole derivatives, for example, 4,4',4"-tri(N-carbazolyl)triphenylamine (TCTA), 9,9-bis[4-(carbazole-9-yl)phenyl]fluorene, 1,3-bis(carbazole-9-yl)benzene (mCP), and 2,2-bis[4-(carbazole-9-yl)phenyl]adamantane (Ad-Cz); and compounds that have a triarylamine structure, for example, 9-[4-(carbazole-9-yl)phenyl]-9-[4-(triphenylsilyl)phenyl]-9H-fluorene, and the like.

The electron blocking layer is formed using one of known electron blocking materials such as those listed above alone, or two or more of the known electron blocking materials in combination. However, a multi-layer film in which a plurality of layers formed using one or more of these electron blocking materials are stacked may also be used as the electron blocking layer.

The light emitting layer 5 of the organic EL element can be formed using a light emitting material such as a metal complex of a quinolinol derivative such as Alq₃. Other examples of the light emitting material include various types of metal complexes of zinc, beryllium, aluminum, and the like, an anthracene derivative, a bisstyrylbenzene derivative, a pyrene derivative, an oxazole derivative, and a polyparaphenylene vinylene derivative.

The light emitting layer 5 can also be formed using a host material and a dopant material.

In this case, as the host material, in addition to the light emitting materials listed above, a thiazole derivative, a benzimidazole derivative, a polydialkylfluorene derivative, and the like can be used. Furthermore, one of the above-described high molecular weight compounds α and β can be used alone, or a mixture of the two compounds can be used.

As the dopant material, quinacridone, coumalin, rubrene, perylene, and derivatives thereof, a benzopyran derivative, a rhodamine derivative, an aminostyryl derivative, and the like can be used.

The light emitting layer 5 described above may have a single-layer configuration that uses one or two or more of the light emitting materials listed above, or a multi-layer structure in which a plurality of layers are stacked.

Furthermore, the light emitting layer 5 can also be formed using a phosphorescent light emitting material as the light emitting material. As the phosphorescent light emitting material, a phosphorescent emitter of a metal complex of iridium, platinum, or the like can be used. For example, a green phosphorescent emitter such as Ir(ppy)₃, a blue phosphorescent emitter such as FIrpic or FIr6, a red phosphorescent emitter such as Btp₂Ir (acac), or the like can be used. The phosphorescent light emitting material is used by being doped into a host material that has hole injectability and transportability or a host material that has electron transportability.

As the host material that has hole injectability and transportability, carbazole derivatives such as 4,4'-di(N-carbazolyl)biphenyl (CBP), TCTA, and mCP can be used, and furthermore, the above-described high molecular weight compounds α and β can also be used.

As the host material that has electron transportability, p-bis(triphenylsilyl)benzene (UGH2), 2,2',2"-(1,3,5-phenylene)-tris(1-phenyl-1H-benzimidazole) (TPBI), and the like can be used.

Note that, in order to avoid concentration quenching, it is preferable to dope the host material with the phosphorescent light emitting material in an amount of 1 to 30 wt% with respect to the entire light emitting layer, and it is preferable to perform the doping through co-deposition.

Also, as the light emitting material, a material that emits delayed fluorescence such as a CDCB derivative, specifically, PIC-TRZ, CC2TA, PXZ-TRZ, 4CzIPN, or the like can also be used. (See Appl. Phys. Let., 98, 083302 (2011).)

An organic EL element having a reduced driving voltage and improved light emission efficiency can be realized by forming the light emitting layer 5 by causing the above-described high molecular weight compounds α and β to carry a fluorescent emitter, a phosphorescent emitter, or a material that emits delayed fluorescence, which are called dopants.

A hole blocking layer (not shown) that may be provided between the light emitting layer 5 and the electron transport layer 6 can be formed using a hole blocking compound that itself is known. Examples of the known hole blocking compound include:
a phenanthroline derivative such as bathocuproine (BCP); a metal complex of a quinolinol derivative such as aluminum(III)bis(2-methyl-8-quinolinate)-4-phenylphenolate (hereinafter referred to simply as BAlq); various types of rare-earth complexes; a triazole derivative; a triazine derivative; an oxadiazole derivative; and the like.

These materials can also be used to form the electron transport layer 6, which will be described below, and, furthermore, can also be used as a material for forming a layer that serves as both the hole blocking layer and the electron transport layer 6.

The hole blocking layer may also have a single-layer structure or a multi-layer stack structure, in which each layer is formed using one or two or more of the hole blocking compounds listed above.

The electron transport layer 6 is formed using an electron transporting compound that itself is known. Examples of the known electron transporting compound include metal complexes of quinolinol derivatives such as Alq₃ and BAlq, various types of metal complexes, a pyridine derivative, a pyrimidine derivative, a triazole derivative, a triazine derivative, an oxadiazole derivative, a thiadiazole derivative, a carbodiimide derivative, a quinoxaline derivative, a phenanthroline derivative, a silole derivative, a benzimidazole derivative, and the like.

The electron transport layer 6 may also have a single-layer structure or a multi-layer stack structure, in which each layer is formed using one or two or more of the electron transporting compounds listed above.

Furthermore, an electron injection layer (not shown) that may be formed as necessary can also be formed using a material that itself is known. Examples thereof include alkali metal salts such as lithium fluoride and cesium fluoride; alkaline earth metal salts such as magnesium fluoride; metal oxides such as aluminum oxide; organic metal complexes such as lithium quinoline; and the like.

The negative electrode 7 of the organic EL element is formed using an electrode material that has a low work function, such as aluminum, or an electrode material made of an alloy that has an even lower work function, such as a magnesium-silver alloy, a magnesium-indium alloy, or an aluminum-magnesium alloy.

In the present invention, at least one of the hole injection layer 3, the hole transport layer 4, the light emitting layer 5, and the electron blocking layer, which is not shown, is formed using two or more high molecular weight compounds including the above-described high molecular weight compounds α and β. As a result, an organic EL element that has high light emission efficiency, high power efficiency, a low actual driving voltage, and outstanding durability can be obtained. In particular, the organic EL element has a reduced driving voltage, improved current tolerance, and improved maximum light emission luminance while having high light emission efficiency.

### Examples

Hereinafter, the present invention will be described using experimental examples below.

For details of synthesis used in the present invention to produce for a high molecular weight compound having a structural unit represented by the general formula (1), see WO 2018/168667. Also, for details of synthesis for producing a high molecular weight compound having a structural unit represented by the general formula (6), see WO 2020/009069.

Structural units contained in high molecular weight compounds that were synthesized in the experimental examples below will be referred to as follows.
Structural unit A: structural unit represented by general formula (1)
Structural unit B: structural unit represented by general formula (2a)
Structural unit C: structural unit represented by general formula (3e)
Structural unit D: structural unit represented by general formula (4)
Structural unit E: structural unit represented by general formula (5)
Structural unit F: structural unit represented by general formula (3y)
Structural unit G: structural unit represented by general formula (2v)

### Example 1

### <Synthesis of High Molecular Weight Compound I>

The following components were placed into a nitrogen-purged reaction vessel, and a nitrogen gas was passed therethrough for 30 minutes.
2,7-Bis(4,4,5,5-tetramethyl-1,3,2-dioxaborolan-2-yl)-9,9-di-n-octylfulorene: 6.5 g
N,N-bis(4-bromophenyl)-4-(2-naphthalenyl)-[1,1':2',1"-terphenyl]-4'-amine: 5.5 g
N,N-bis(4-bromophenyl)-bicyclo[4.2.0]octa-1,3,5-trien-3-amine: 0.87 g
Tripotassium phosphate: 9.0 g
Toluene: 16 ml
Water: 9 ml
1,4-Dioxane: 48 ml

Then, 1.9 mg of palladium(II) acetate and 15.0 mg of tri-o-tolylphosphine were added thereto, and the mixture was heated, and stirred at 88°C for 10 hours. After that, 22 mg of phenylboronic acid was added, followed by stirring for 1 hour, and then, 0.32 g of bromobenzene was added, followed by stirring for 1 hour. Subsequently, 100 ml of toluene and 100 ml of a 5 wt% sodium N,N-diethyldithiocarbamate aqueous solution were added, and the mixture was heated, and stirred under reflux for 2 hours.

Then, after the mixture was cooled to room temperature, brine and toluene were added thereto, and the organic layer was collected by performing a separation operation. The organic layer was dehydrated with anhydrous magnesium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 300 ml of toluene thereto, the solution was added dropwise to 600 ml of n-hexane, and the resulting precipitate was filtered out. This operation was repeated three times, followed by drying. Thus, 8.0 g (yield 92%) of a high molecular weight compound I was obtained.

The average molecular weight measured using GPC and the degree of dispersion of the high molecular weight compound I were as follows.
Number average molecular weight Mn (in terms of polystyrene): 45,000
Weight average molecular weight Mw (in terms of polystyrene): 97,000
Degree of dispersion (Mw/Mn): 2.1

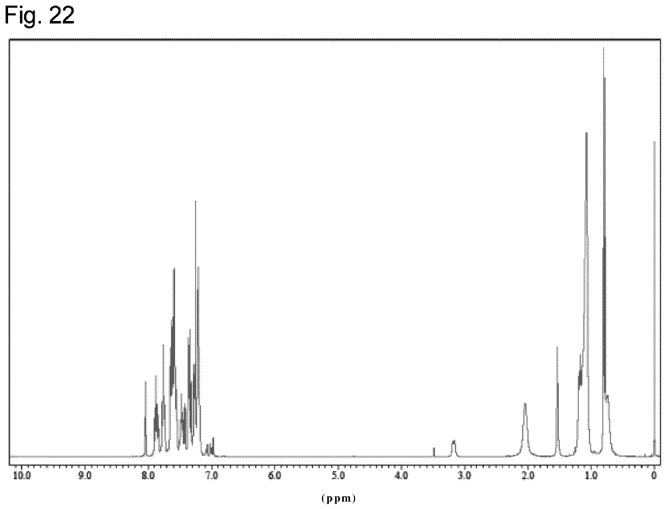

Also, the high molecular weight compound I was subjected to NMR measurement. Fig. 22 shows the result of ¹H-NMR measurement. The chemical composition formula was as follows.

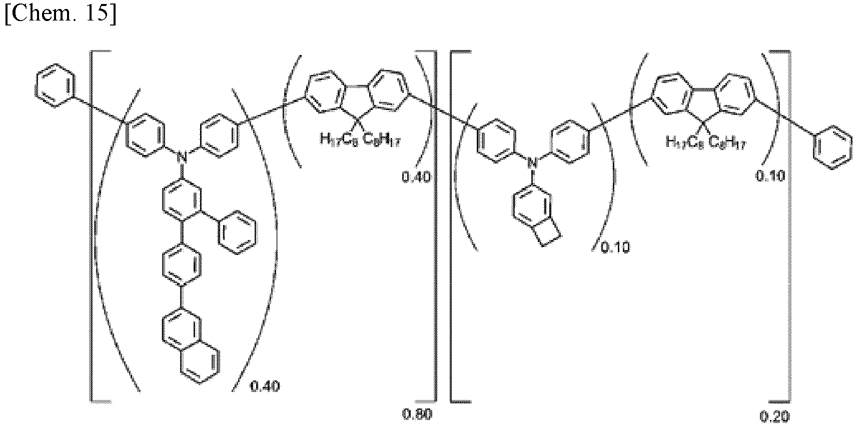

### (High molecular weight compound I)

As can be understood from the chemical composition above, the high molecular weight compound I contained the structural unit A in an amount of 40 mol%, the structural unit B in an amount of 50 mol%, and, furthermore, the structural unit C in an amount of 10 mol%.

### Example 2

### <Synthesis of High Molecular Weight Compound II>

The following components were placed into a nitrogen-purged reaction vessel, and a nitrogen gas was passed therethrough for 30 minutes.
9,9-Dioctyl-N,N-bis[4-(4,4,5,5-tetramethyl-1,3,2-dioxaborolan-2-yl)phenyl]-9H-fluoren -2-amine: 5.0 g
3-Dibromobenzene: 1.8 g
N,N-bis[4-(4,4,5,5-tetramethyl-1,3,2-dioxaborolan-2-yl)phenyl]bicyclo[4.2.0]octa-1,3,5 -trien-3-amine: 0.8 g
Tripotassium phosphate: 6.9 g
Toluene: 9 ml
Water: 5 ml
1,4-Dioxane: 27 ml

Then, 1.4 mg of palladium(II) acetate and 11.5 mg of tri-o-tolylphosphine were added thereto, and the mixture was heated, and stirred at 87°C for 14 hours. After that, 17 mg of phenylboronic acid was added, followed by stirring for 1 hour, and then, 242 mg of bromobenzene was added, followed by stirring for 1 hour. Subsequently, 50 ml of toluene and 50 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous magnesium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 100 ml of toluene thereto, the solution was added dropwise to 300 ml of n-hexane, and the resulting precipitate was filtered out. This operation was repeated three times, followed by drying. Thus, 3.5 g (yield 78%) of a high molecular weight compound II was obtained.

The average molecular weight measured using GPC and the degree of dispersion of the high molecular weight compound II were as follows.
Number average molecular weight Mn (in terms of polystyrene): 32,000
Weight average molecular weight Mw (in terms of polystyrene): 55,000
Degree of dispersion (Mw/Mn): 1.7

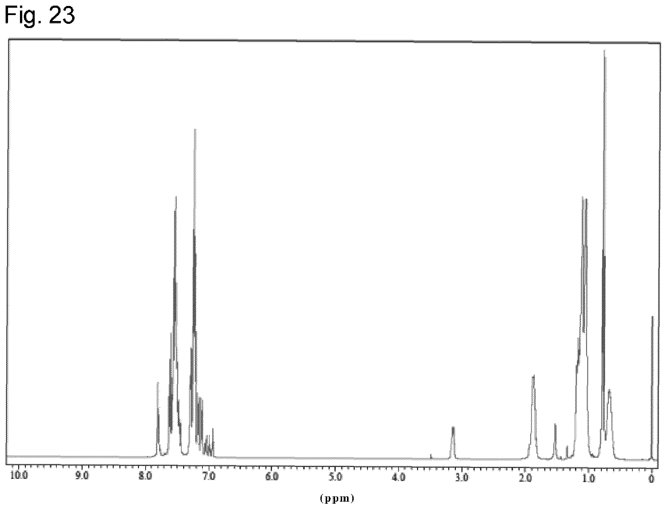

Also, the high molecular weight compound II was subjected to NMR measurement. Fig. 23 shows the result of ¹H-NMR measurement. The chemical composition formula was as follows.

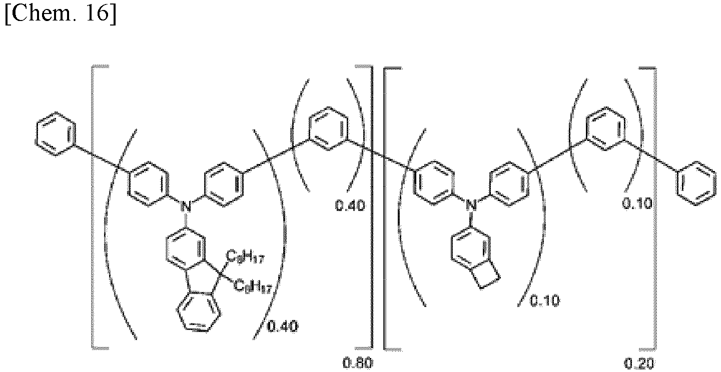

### (High molecular weight compound II)

As can be understood from the chemical composition above, the high molecular weight compound II contained the structural unit D in an amount of 40 mol%, the structural unit E in an amount of 50 mol%, and, furthermore, the structural unit C in an amount of 10 mol%.

### Example 3

### <Synthesis of High Molecular Weight Compound III>

The following components were placed into a nitrogen-purged reaction vessel, and a nitrogen gas was passed therethrough for 30 minutes.
4-(9,9-Dioctyl-9H-fluoren-2-yl)-N,N-bis[4-(4,4,5,5-tetramethyl-1,3,2-dioxaborolan-2-yl )phenyl]-benzenamine: 5.0 g
1,3-Dibromobenzene: 1.7 g
N,N-Bis[4-(4,4,5,5-tetramethyl-1,3,2-dioxaborolan-2-yl)phenyl]bicyclo[4.2.0]octa-1,3,5 -trien-3-amine: 0.7 g
Tripotassium phosphate: 6.3 g
Toluene: 9 ml
Water: 5 ml
1,4-Dioxane: 27 ml

Then, 1.3 mg of palladium(II) acetate and 10.5 mg of tri-o-tolylphosphine were added thereto, and the mixture was heated, and stirred at 88°C for 11 hours. After that, 16 mg of phenylboronic acid was added, followed by stirring for 1 hour, and then, 222 mg of bromobenzene was added, followed by stirring for 1 hour. Subsequently, 50 ml of toluene and 50 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous magnesium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 100 ml of toluene thereto, the solution was added dropwise to 100 ml of n-hexane, and the resulting precipitate was filtered out. This operation was repeated three times, followed by drying. Thus, 2.2 g (yield 48%) of a high molecular weight compound III was obtained.

The average molecular weight measured using GPC and the degree of dispersion of the high molecular weight compound III were as follows.
Number average molecular weight Mn (in terms of polystyrene): 55,000
Weight average molecular weight Mw (in terms of polystyrene): 93,000
Degree of dispersion (Mw/Mn): 1.7

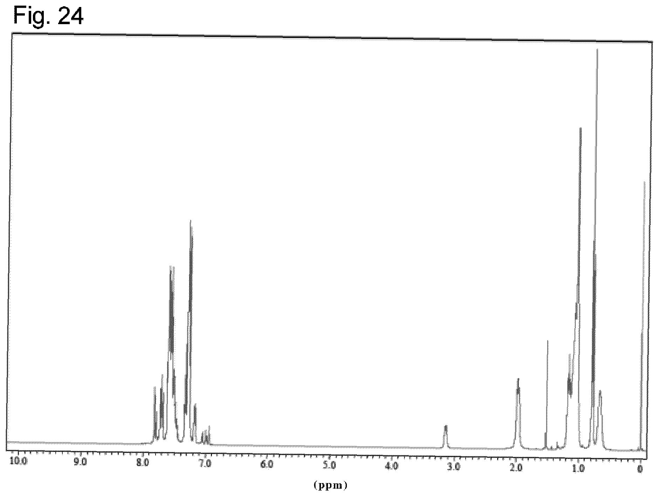

Also, the high molecular weight compound III was subjected to NMR measurement. Fig. 24 shows the result of ¹H-NMR measurement. The chemical composition formula was as follows.

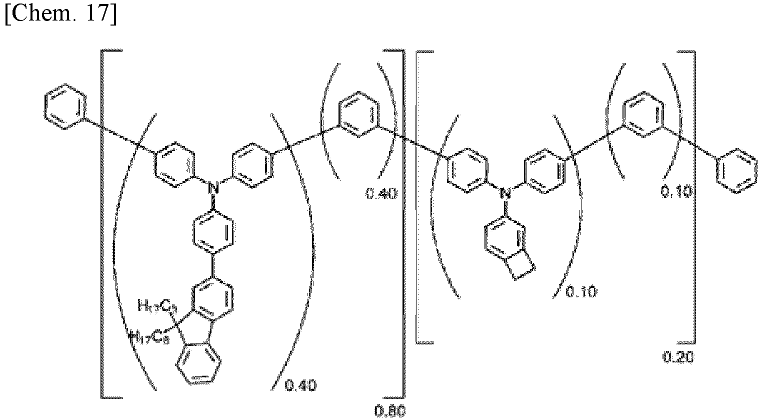

### (High molecular weight compound III)

As can be understood from the chemical composition above, the high molecular weight compound III contained the structural unit D in an amount of 40 mol%, the structural unit E in an amount of 50 mol%, and, furthermore, the structural unit C in an amount of 10 mol%.

### Example 4

### <Synthesis of High Molecular Weight Compound IV>

The following components were placed into a nitrogen-purged reaction vessel, and a nitrogen gas was passed therethrough for 30 minutes.
9,9-Dioctyl-N,N-bis[4-(4,4,5,5-tetramethyl-1,3,2-dioxaborolan-2-yl)phenyl]-9H-fluoren -2-amine: 3.4 g
9-(3,5-Dibromophenyl)-9H-carbazole: 2.1 g
N,N-bis[4-(4,4,5,5-tetramethyl-1,3,2-dioxaborolan-2-yl)phenyl]bicyclo[4.2.0]octa-1,3,5 -trien-3-amine: 0.5 g
Tripotassium phosphate: 4.7 g
Toluene: 7 ml
Water: 4 ml
1,4-Dioxane: 21 ml

Then, 5 mg of tetrakistriphenylphosphine palladium(0) was added thereto, and the mixture was heated, and stirred at 90°C for 19.5 hours. After that, 12 mg of phenylboronic acid was added, followed by stirring for 1 hour, and then, 165 mg of bromobenzene was added, followed by stirring for 1 hour. Subsequently, 50 ml of toluene and 50 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous magnesium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 80 ml of toluene thereto, the solution was added dropwise to 240 ml of n-hexane, and the resulting precipitate was filtered out. This operation was repeated three times, followed by drying. Thus, 3.0 g (yield 80%) of a high molecular weight compound IV was obtained.

The average molecular weight measured using GPC and the degree of dispersion of the high molecular weight compound IV were as follows.
Number average molecular weight Mn (in terms of polystyrene): 35,000
Weight average molecular weight Mw (in terms of polystyrene): 69,000
Degree of dispersion (Mw/Mn): 2.0

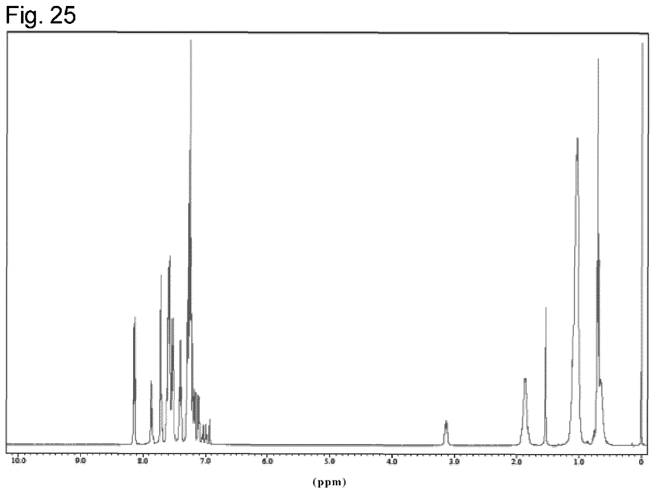

Also, the high molecular weight compound IV was subjected to NMR measurement. Fig. 25 shows the result of ¹H-NMR measurement. The chemical composition formula was as follows.

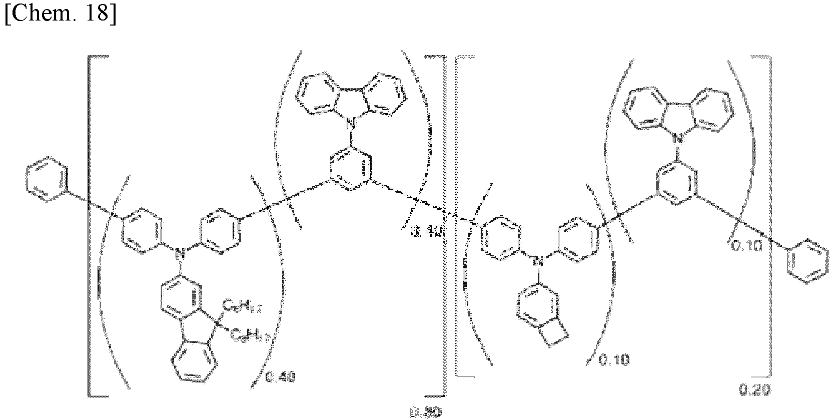

### (High molecular weight compound IV)

As can be understood from the chemical composition above, the high molecular weight compound IV contained the structural unit D in an amount of 40 mol%, the structural unit E in an amount of 50 mol%, and, furthermore, the structural unit C in an amount of 10 mol%.

### Example 5

### <Synthesis of High Molecular Weight Compound V>

The following components were placed into a nitrogen-purged reaction vessel, and a nitrogen gas was passed therethrough for 30 minutes.
9,9-Dioctyl-N,N-bis[4-(4,4,5,5-tetramethyl-1,3,2-dioxaborolan-2-yl)phenyl]-9H-fluoren -2-amine: 5.0 g
1,3-Dibromobenzene: 1.8 g
2,2'-(5-Bicyclo[4.2.0]octa-1,3,5-trien-3-yl-1,3-phenylene)bis[4,4,5,5-tetramethyl-1,3,2-dioxaborolan]: 0.7 g
Tripotassium phosphate: 6.9 g
Toluene: 9 ml
Water:5 ml
1,4-Dioxane: 27 ml

Then, 1.4 mg of palladium(II) acetate and 11.5 mg of tri-o-tolylphosphine were added thereto, and the mixture was heated, and stirred at 80°C for 14 hours. After that, 17 mg of phenylboronic acid was added, followed by stirring for 1 hour, and then, 242 mg of bromobenzene was added, followed by stirring for 1 hour. Subsequently, 100 ml of toluene and 50 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous magnesium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 100 ml of toluene thereto, the solution was added dropwise to 300 ml of n-hexane, and the resulting precipitate was filtered out. This operation was repeated three times, followed by drying. Thus, 3.2 g (yield 73%) of a high molecular weight compound V was obtained.

The average molecular weight measured using GPC and the degree of dispersion of the high molecular weight compound V were as follows.
Number average molecular weight Mn (in terms of polystyrene): 44,000
Weight average molecular weight Mw (in terms of polystyrene): 71,000
Degree of dispersion (Mw/Mn): 1.6

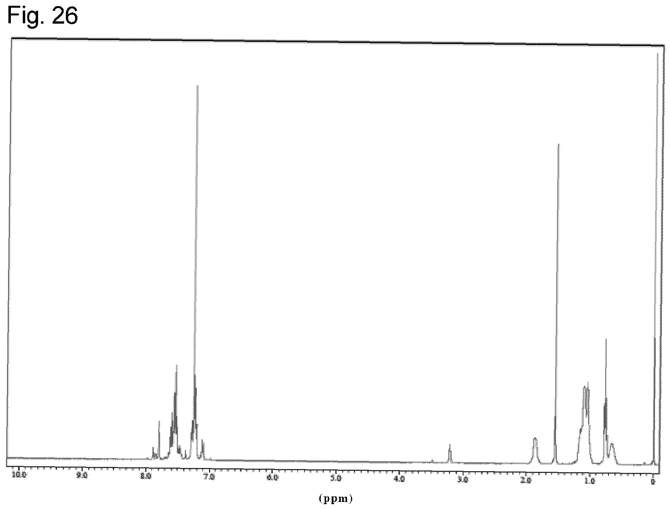

Also, the high molecular weight compound V was subjected to NMR measurement. Fig. 26 shows the result of ¹H-NMR measurement. The chemical composition formula was as follows.

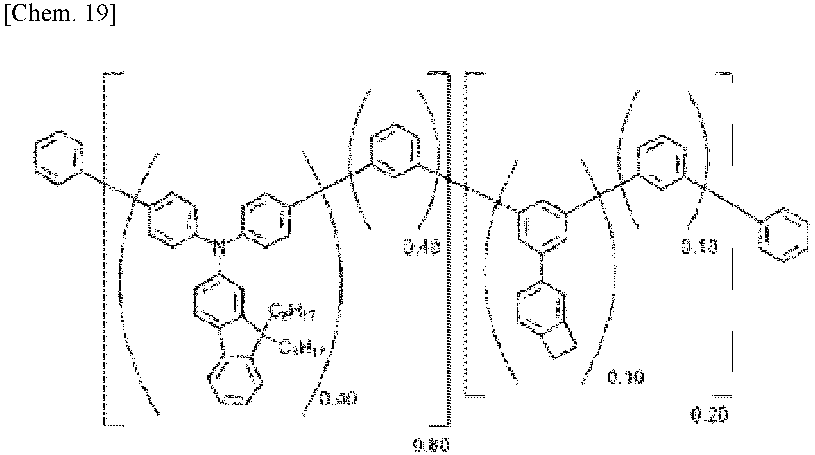

### (High molecular weight compound V)

As can be understood from the chemical composition above, the high molecular weight compound V contained the structural unit D in an amount of 40 mol%, the structural unit E in an amount of 50 mol%, and, furthermore, the structural unit F in an amount of 10 mol%.

### Example 6

### <Synthesis of High Molecular Weight Compound VI>

The following components were placed into a nitrogen-purged reaction vessel, and a nitrogen gas was passed therethrough for 30 minutes.
9,9-Dioctyl-N,N-bis[3-(4,4,5,5-tetramethyl-1,3,2-dioxaborolan-2-yl)phenyl]-9H-fluoren -2-amine: 5.0 g
1,3-Dibromobenzene: 1.8 g
N,N-Bis[4-(4,4,5,5-tetramethyl-1,3,2-dioxaborolan-2-yl)phenyl]bicyclo[4.2.0]octa-1,3,5 -trien-3-amine: 0.8 g
Tripotassium phosphate: 6.9 g
Toluene: 9 ml
Water: 5 ml
1,4-Dioxane: 27 ml

Then, 1.4 mg of palladium(II) acetate and 11.5 mg of tri-o-tolylphosphine were added thereto, and the mixture was heated, and stirred at 88°C for 12 hours. After that, 17 mg of phenylboronic acid was added, followed by stirring for 1 hour, and then, 242 mg of bromobenzene was added, followed by stirring for 1 hour. Subsequently, 50 ml of toluene and 50 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous sodium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 50 ml of toluene thereto, the solution was added dropwise to 300 ml of n-hexane, and the resulting precipitate was filtered out. This operation was repeated three times, followed by drying. Thus, 2.2 g (yield 48%) of a high molecular weight compound VI was obtained.

The average molecular weight measured using GPC and the degree of dispersion of the high molecular weight compound VI were as follows.
Number average molecular weight Mn (in terms of polystyrene): 25,000
Weight average molecular weight Mw (in terms of polystyrene): 37,000
Degree of dispersion (Mw/Mn): 1.5

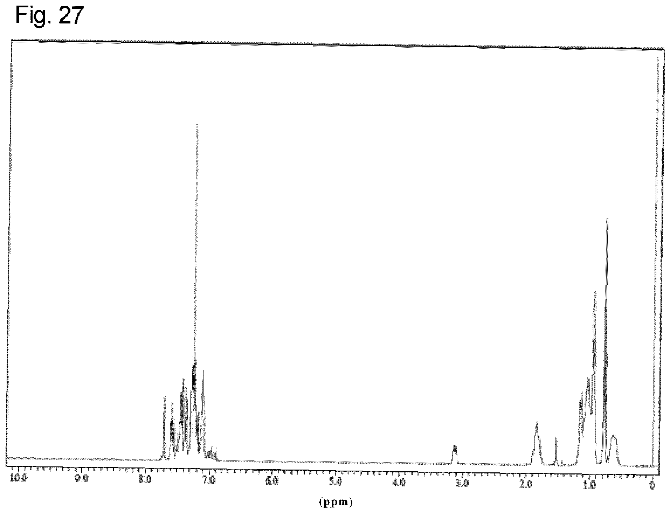

Also, the high molecular weight compound VI was subjected to NMR measurement. Fig. 27 shows the result of ¹H-NMR measurement. The chemical composition formula was as follows.

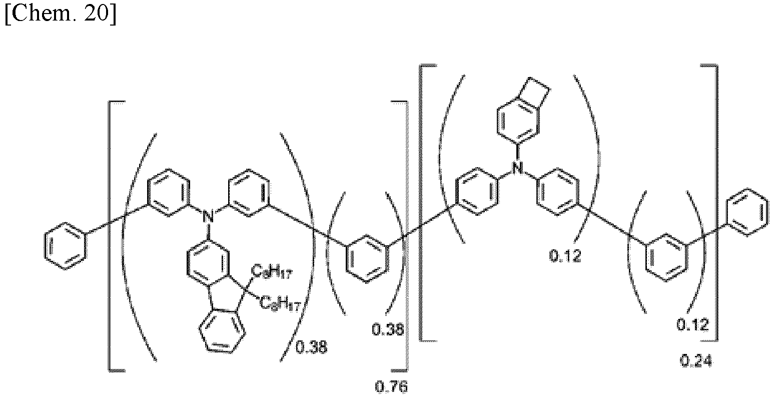

### (High molecular weight compound VI)

As can be understood from the chemical composition above, the high molecular weight compound VI contained the structural unit D in an amount of 38 mol%, the structural unit E in an amount of 50 mol%, and, furthermore, the structural unit C in an amount of 12 mol%.

### Example 7

### <Synthesis of High Molecular Weight Compound VII>

The following components were placed into a nitrogen-purged reaction vessel, and a nitrogen gas was passed therethrough for 30 minutes.
2,7-Bis(4,4,5,5-tetramethyl-1,3,2-dioxaborolan-2-yl)-9,9-di-n-octylfulorene: 6.9 g N,N-bis(4-bromophenyl)-4-(2-naphthalenyl)-[1,1':2',1"-terphenyl]-4'-amine: 6.5 g Tripotassium phosphate: 9.0 g
Toluene: 16 ml
Water: 9 ml
1,4-Dioxane: 48 ml

Then, 1.9 mg of palladium(II) acetate and 15.1 mg of tri-o-tolylphosphine were added thereto, and the mixture was heated, and stirred at 85°C for 14 hours. After that, 22 mg of phenylboronic acid was added, followed by stirring for 1 hour, and then, 0.3 g of bromobenzene was added, followed by stirring for 1 hour. Subsequently, 100 ml of toluene and 100 ml of a 5 wt% sodium N,N-diethyldithiocarbamate aqueous solution were added, and the mixture was heated, and stirred under reflux for 1 hour. After the mixture was cooled to room temperature, the organic layer was collected by performing a separation operation and washed three times with brine. The organic layer was dehydrated with anhydrous sodium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 200 ml of toluene thereto, the solution was added dropwise to 400 ml of n-hexane, and the resulting precipitate was filtered out. This operation was repeated three times, followed by drying. Thus, 8.7 g (yield 92%) of a high molecular weight compound VII was obtained.

The average molecular weight measured using GPC and the degree of dispersion of the high molecular weight compound VII were as follows.
Number average molecular weight Mn (in terms of polystyrene): 38,000
Weight average molecular weight Mw (in terms of polystyrene): 84,000
Degree of dispersion (Mw/Mn): 2.2

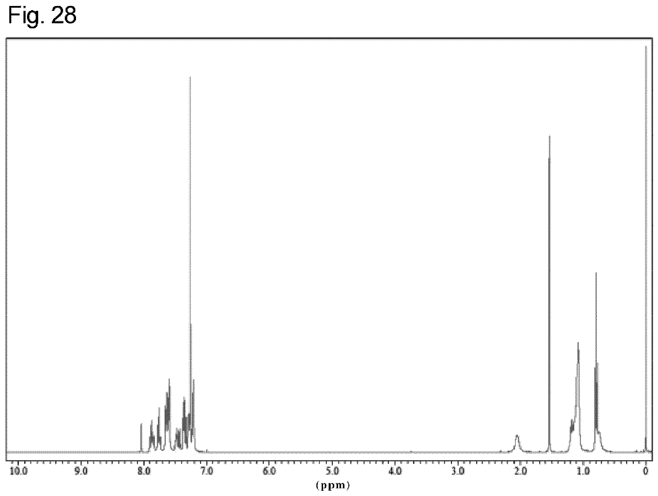

Also, the high molecular weight compound VII was subjected to NMR measurement. Fig. 28 shows the result of ¹H-NMR measurement. The chemical composition formula was as follows.

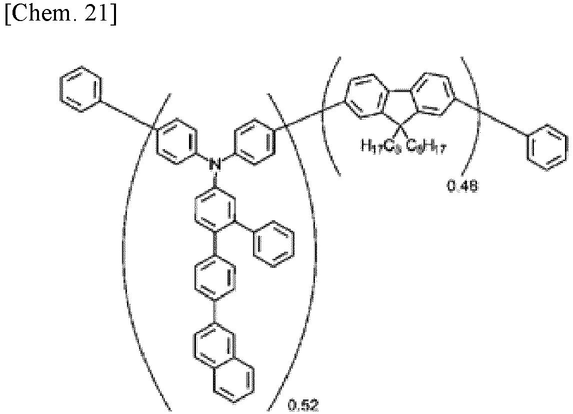

### (High molecular weight compound VII)

As can be understood from the chemical composition above, the high molecular weight compound VII contained the structural unit A in an amount of 52 mol% and the structural unit B in an amount of 48 mol%.

### Example 8

### <Synthesis of High Molecular Weight Compound VIII>

The following components were placed into a nitrogen-purged reaction vessel, and a nitrogen gas was passed therethrough for 30 minutes.
N,N-bis[4-(4,4,5,5-tetramethyl-1,3,2-dioxaborolan-2-yl)phenyl]-9,9-dioctyl-9H-fluoren-2-amine: 5.6 g
1,3-Dibromobenzene: 1.6 g
Tripotassium phosphate: 7.7 g
Toluene: 9 ml
Water: 5 ml
1,4-Dioxane: 27 ml

Then, 1.6 mg of palladium(II) acetate and 12.9 mg of tri-o-tolylphosphine were added thereto, and the mixture was heated, and stirred at 85°C for 11 hours. After that, 19 mg of phenylboronic acid was added, followed by stirring for 1 hour, and then, 271 mg of bromobenzene was added, followed by stirring for 1 hour. Subsequently, 50 ml of toluene and 50 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous magnesium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 100 ml of toluene thereto, the solution was added dropwise to 300 ml of n-hexane, and the resulting precipitate was filtered out. This operation was repeated three times, followed by drying. Thus, 3.2 g (yield 70%) of a high molecular weight compound VIII was obtained.

The average molecular weight measured using GPC and the degree of dispersion of the high molecular weight compound VIII were as follows.
Number average molecular weight Mn (in terms of polystyrene): 56,000
Weight average molecular weight Mw (in terms of polystyrene): 89,000
Degree of dispersion (Mw/Mn): 1.6

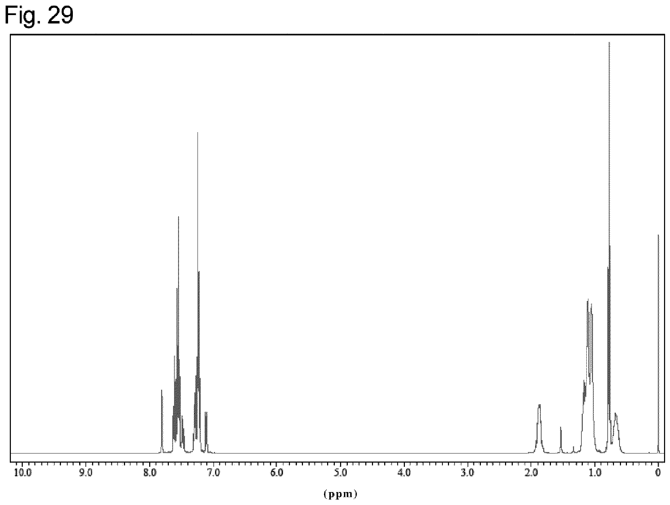

Also, the high molecular weight compound VIII was subjected to NMR measurement. Fig. 29 shows the result of ¹H-NMR measurement. The chemical composition formula was as follows.

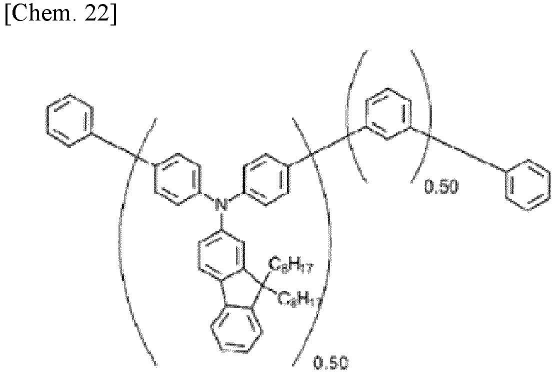

### (High molecular weight compound VIII)

As can be understood from the chemical composition above, the high molecular weight compound VIII contained the structural unit D in an amount of 50 mol% and the structural unit E in an amount of 50 mol%.

### Example 9

### <Synthesis of High Molecular Weight Compound IX>

The following components were placed into a nitrogen-purged reaction vessel, and a nitrogen gas was passed therethrough for 30 minutes.
9,9-Dioctyl-N,N-bis[3-(4,4,5,5-tetramethyl-1,3,2-dioxaborolan-2-yl)phenyl]-9H-fluoren -2-amine: 6.6 g
1,3-Dibromobenzene: 1.9 g
Tripotassium phosphate: 9.1 g
Toluene: 12 ml
Water: 7 ml
1,4-Dioxane: 36 ml

Then, 1.9 mg of palladium(II) acetate and 15.1 mg of tri-o-tolylphosphine were added thereto, and the mixture was heated, and stirred at 85°C for 11.5 hours. After that, 23 mg of phenylboronic acid was added, followed by stirring for 1 hour, and then, 319 mg of bromobenzene was added, followed by stirring for 1 hour. Subsequently, 50 ml of toluene and 50 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous sodium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 30 ml of toluene thereto, the solution was added dropwise to 400 ml of n-hexane, and the resulting precipitate was filtered out. This operation was repeated once again, followed by drying. Thus, 1.6 g (yield 30%) of a high molecular weight compound IX was obtained.

The average molecular weight measured using GPC and the degree of dispersion of the high molecular weight compound IX were as follows.
Number average molecular weight Mn (in terms of polystyrene): 38,000
Weight average molecular weight Mw (in terms of polystyrene): 50,000
Degree of dispersion (Mw/Mn): 1.3

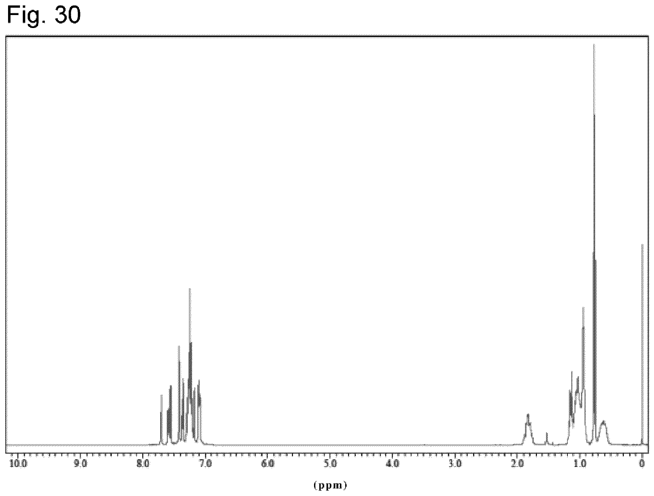

Also, the high molecular weight compound IX was subjected to NMR measurement. Fig. 30 shows the result of ¹H-NMR measurement. The chemical composition formula was as follows.

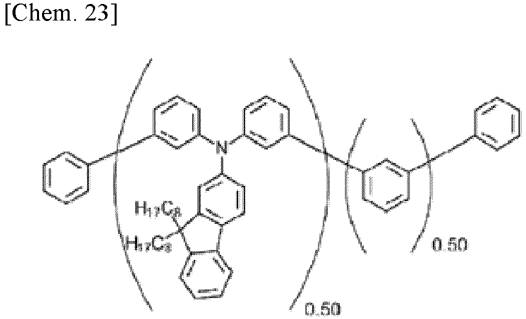

### (High molecular weight compound IX)

As can be understood from the chemical composition above, the high molecular weight compound IX contained the structural unit D in an amount of 50 mol% and the structural unit E in an amount of 50 mol%.

### Example 10

### <Synthesis of High Molecular Weight Compound X>

The following components were placed into a nitrogen-purged reaction vessel, and a nitrogen gas was passed therethrough for 30 minutes.
2,7-Bis(4,4,5,5-tetramethyl-1,3,2-dioxaborolan-2-yl)-9,9-di-n-octylfulorene: 6.5 g N,N-bis(4-bromophenyl)-4-(2-naphthalenyl)-[1,1':2',1"-terphenyl]-4'-amine: 5.5 g 4,4'-Dibromotriphenylamine: 0.8 g
Tripotassium phosphate: 9.0 g
Toluene: 16 ml
Water: 9 ml
1,4-Dioxane: 48 ml

Then, 2.0 mg of palladium(II) acetate and 15.1 mg of tri-o-tolylphosphine were added thereto, and the mixture was heated, and stirred at 80°C for 12.5 hours. After that, 22 mg of phenylboronic acid was added, followed by stirring for 1 hour, and then, 0.3 g of bromobenzene was added, followed by stirring for 1 hour. Subsequently, 100 ml of toluene and 100 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous magnesium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 200 ml of toluene thereto, the solution was added dropwise to 400 ml of n-hexane, and the resulting precipitate was filtered out. This operation was repeated three times, followed by drying. Thus, 7.8 g (yield 90%) of a high molecular weight compound X was obtained.

The average molecular weight measured using GPC and the degree of dispersion of the high molecular weight compound X were as follows.
Number average molecular weight Mn (in terms of polystyrene): 44,000
Weight average molecular weight Mw (in terms of polystyrene): 89,000
Degree of dispersion (Mw/Mn): 2.0

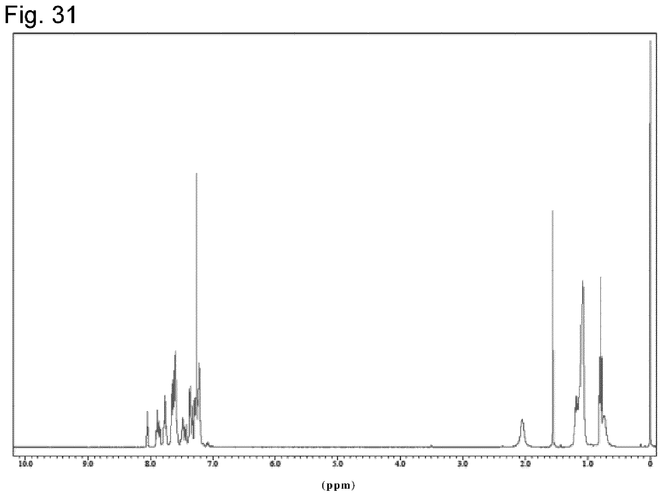

Also, the high molecular weight compound X was subjected to NMR measurement. Fig. 31 shows the result of ¹H-NMR measurement. The chemical composition formula was as follows.

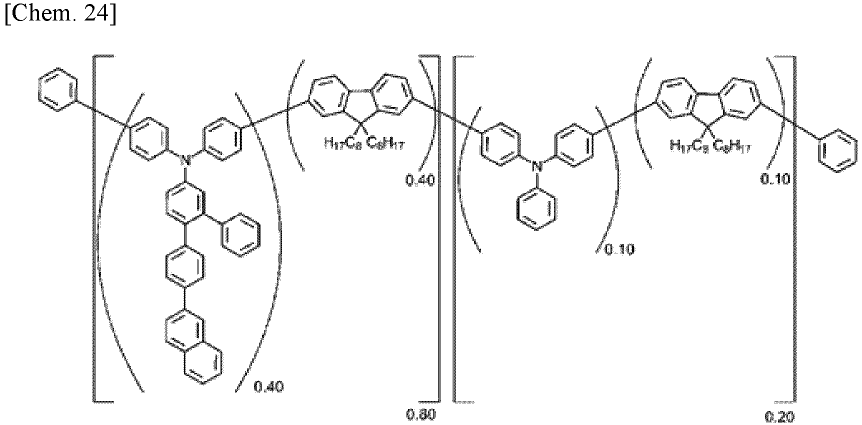

### (High molecular weight compound X)

As can be understood from the chemical composition above, the high molecular weight compound X contained the structural unit A in an amount of 40 mol%, the structural unit B in an amount of 50 mol%, and, furthermore, the structural unit G in an amount of 10 mol%.

### Example 11

### <Synthesis of High Molecular Weight Compound XI>

The following components were placed into a nitrogen-purged reaction vessel, and a nitrogen gas was passed therethrough for 30 minutes.
9,9-Dioctyl-N,N-bis[4-(4,4,5,5-tetramethyl-1,3,2-dioxaborolan-2-yl)phenyl]-9H-fluoren -2-amine: 5.0 g
1,3-Dibromobenzene: 1.8 g
N-phenyl-4-(4,4,5,5-tetramethyl-1,3,2-dioxaborolan-2-yl)-N-[4-(4,4,5,5-tetramethyl-1,3 ,2-dioxaborolan-2-yl)phenyl]benzenamine: 0.8 g
Tripotassium phosphate: 6.9 g
Toluene: 9 ml
Water: 5 ml
1,4-Dioxane: 27 ml

Then, 1.4 mg of palladium(II) acetate and 11.5 mg of tri-o-tolylphosphine were added thereto, and the mixture was heated, and stirred at 86°C for 11.5 hours. After that, 17 mg of phenylboronic acid was added, followed by stirring for 1 hour, and then, 242 mg of bromobenzene was added, followed by stirring for 1 hour. Subsequently, 50 ml of toluene and 50 ml of a 5 wt% sodium N,N-diethyldithiocarbamate aqueous solution were added, and the mixture was heated, and stirred under reflux for 2 hours. After the mixture was cooled to room temperature, the organic layer was collected by performing a separation operation and washed three times with brine. The organic layer was dehydrated with anhydrous magnesium sulfate, and then concentrated under reduced pressure to thereby obtain a crude polymer. The crude polymer was dissolved in toluene, silica gel was added thereto to perform adsorption purification, and the silica gel was removed by filtration. The obtained filtrate was concentrated under reduced pressure, the resulting dry solid product was dissolved by adding 100 ml of toluene thereto, the solution was added dropwise to 300 ml of n-hexane, and the resulting precipitate was filtered out. This operation was repeated three times, followed by drying. Thus, 3.4 g (yield 75%) of a high molecular weight compound XI was obtained.

The average molecular weight measured using GPC and the degree of dispersion of the high molecular weight compound XI were as follows.
Number average molecular weight Mn (in terms of polystyrene): 32,000
Weight average molecular weight Mw (in terms of polystyrene): 54,000
Degree of dispersion (Mw/Mn): 1.7

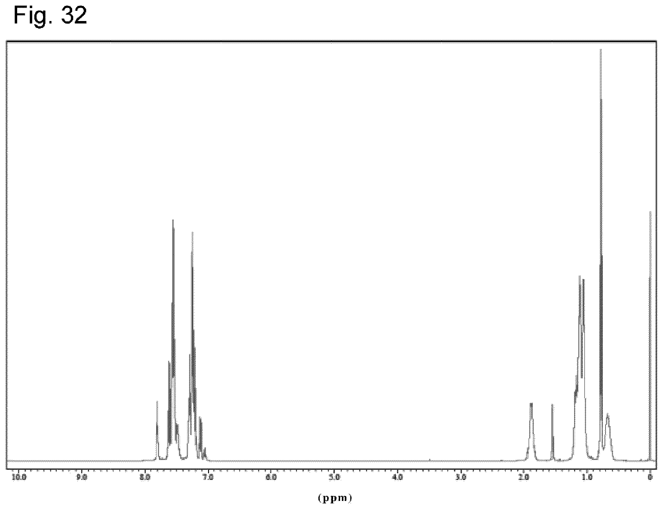

Also, the high molecular weight compound XI was subjected to NMR measurement. Fig. 32 shows the result of ¹H-NMR measurement. The chemical composition formula was as follows.

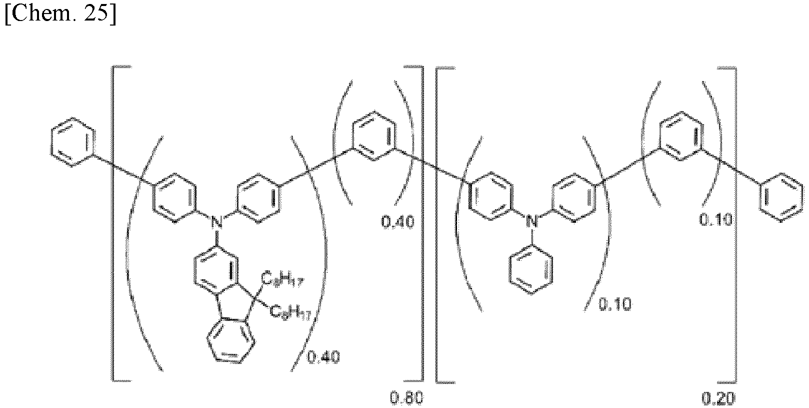

### (High molecular weight compound XI)

As can be understood from the chemical composition above, the high molecular weight compound XI contained the structural unit D in an amount of 40 mol%, the structural unit E in an amount of 50 mol%, and, furthermore, the structural unit G in an amount of 10 mol%.

### Example 12

### <Production and Evaluation of Organic EL Element: Use of High Molecular Weight Compound Having Thermal Crosslinkable Structural Unit>

An organic EL element having a layer structure shown in Fig. 21 was produced in the following manner.

Specifically, a glass substrate 1 on which an ITO film having a thickness of 50 nm was formed was washed with an organic solvent, and then UV/ozone treatment was performed to wash the surface of the ITO film. A PEDOT/PSS (available from HERAEUS) was applied using a spin coating method so as to cover the transparent positive electrode 2 (ITO) formed on the glass substrate 1, and a 50 nm thick film was thereby formed. The film was dried on a hot plate at 200°C for about 10 minutes, and a hole injection layer 3 was thereby formed.

A coating solution was prepared by mixing the high molecular weight compound I obtained in Example 1 as a high molecular weight compound α having a thermal crosslinkable structural unit and the high molecular weight compound II obtained in Example 2 as a high molecular weight compound β having a thermal crosslinkable structural unit in a weight ratio of 1:1 and dissolving the thus obtained mixture in toluene at a concentration of 0.6 wt%. The substrate on which the hole injection layer 3 was formed in the manner described above was placed into a glove box purged with dry nitrogen and was dried on a hot plate at 230°C for 10 minutes. Then, a coating layer having a thickness of 25 nm was formed on the hole injection layer 3 through spin coating using the coating solution described above, and further dried on a hot plate at 220°C for 30 minutes, and a hole transport layer 4 was thereby formed.

The substrate on which the hole transport layer 4 was formed in the manner described above was set in a vacuum deposition apparatus, and the pressure was reduced to 0.001 Pa or less. A light emitting layer 5 having a thickness of 34 nm was formed on the hole transport layer 4 through dual deposition using a blue light emitting material (EMD-1) and a host material (EMH-1) represented by structure formulae below. In the dual deposition, the ratio of deposition rate was set to EMD-1 : EMH-1 = 4 : 96.

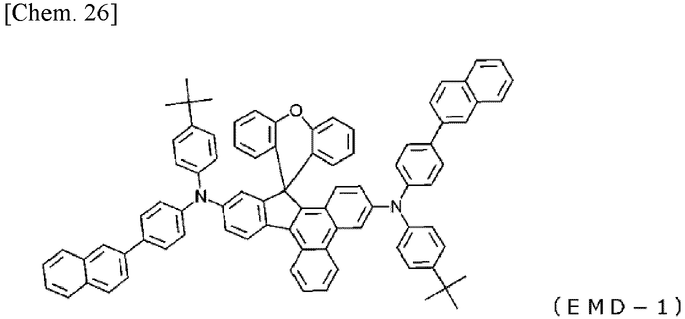

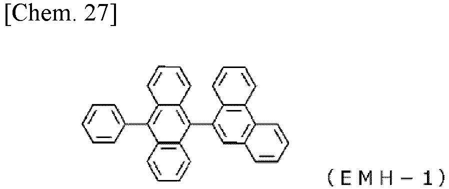

Compounds (ETM-1 and ETM-2) represented by structural formulae below were prepared as electron transport materials.

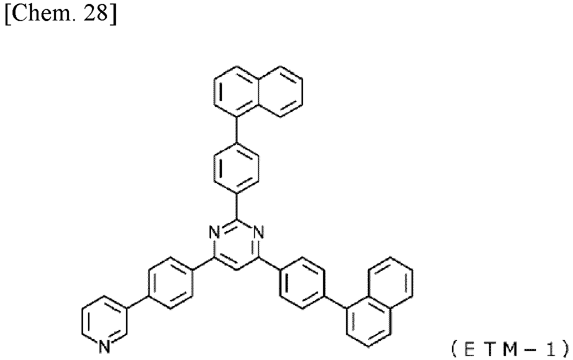

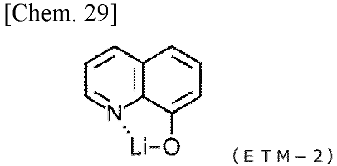

An electron transport layer 6 having a thickness of 20 nm was formed on the light emitting layer 5 formed above through dual deposition using the electron transport materials (ETM-1 and ETM-2). In the dual deposition, the ratio of deposition rate was set to ETM-1 : ETM-2 = 50 : 50.

Finally, aluminum was deposited so as to form a film having a thickness of 100 nm, and a negative electrode 7 was thereby formed.

The glass substrate on which the transparent positive electrode 2, the hole injection layer 3, the hole transport layer 4, the light emitting layer 5, the electron transport layer 6, and the negative electrode 7 were formed was placed into a glove box purged with dry nitrogen, and another glass substrate for sealing was bonded to the glass substrate using a UV curable resin, and an organic EL element was thereby produced. The characteristics of the produced organic EL element were measured in an atmosphere at room temperature. Also, light emission characteristics when a DC voltage was applied to the produced organic EL element were measured. Table 1 shows the measurement results.

### Example 13

An organic EL element was produced in the same manner as in Example 12, except that the high molecular weight compound I and the high molecular weight compound II were mixed in a weight ratio of 2:3, instead of the weight ratio of 1:1. Various characteristics of this organic EL element were evaluated in a manner similar to that used in Example 12. Table 1 shows the results.

### Example 14

An organic EL element was produced in the same manner as in Example 12, except that the high molecular weight compound I and the high molecular weight compound II were mixed in a weight ratio of 3:2, instead of the weight ratio of 1:1. Various characteristics of this organic EL element were evaluated in a manner similar to that used in Example 12. Table 1 shows the results.

### Example 15

An organic EL element was produced in the same manner as in Example 12, except that the high molecular weight compound III obtained in Example 3 was used instead of the high molecular weight compound II. Various characteristics of this organic EL element were evaluated in a manner similar to that used in Example 12. Table 1 shows the results.

### Example 16

An organic EL element was produced in the same manner as in Example 12, except that the high molecular weight compound III obtained in Example 3 was used instead of the high molecular weight compound II, and the high molecular weight compound I and the high molecular weight compound III were mixed in a weight ratio of 2:3. Various characteristics of this organic EL element were evaluated in a manner similar to that used in Example 12. Table 1 shows the results.

### Example 17

An organic EL element was produced in the same manner as in Example 12, except that the high molecular weight compound III obtained in Example 3 was used instead of the high molecular weight compound II, and the high molecular weight compound I and the high molecular weight compound III were mixed in a weight ratio of 3:2. Various characteristics of this organic EL element were evaluated in a manner similar to that used in Example 12. Table 1 shows the results.

### Example 18

An organic EL element was produced in the same manner as in Example 12, except that the high molecular weight compound IV obtained in Example 4 was used instead of the high molecular weight compound II. Various characteristics of this organic EL element were evaluated in a manner similar to that used in Example 12. Table 1 shows the results.

### Example 19

An organic EL element was produced in the same manner as in Example 12, except that the high molecular weight compound IV obtained in Example 4 was used instead of the high molecular weight compound II, and the high molecular weight compound I and the high molecular weight compound IV were mixed in a weight ratio of 2:3. Various characteristics of this organic EL element were evaluated in a manner similar to that used in Example 12. Table 1 shows the results.

### Example 20

An organic EL element was produced in the same manner as in Example 12, except that the high molecular weight compound IV obtained in Example 4 was used instead of the high molecular weight compound II, and the high molecular weight compound I and the high molecular weight compound IV were mixed in a weight ratio of 3:2. Various characteristics of this organic EL element were evaluated in a manner similar to that used in Example 12. Table 1 shows the results.

### Example 21

An organic EL element was produced in the same manner as in Example 12, except that the high molecular weight compound V obtained in Example 5 was used instead of the high molecular weight compound II. Various characteristics of this organic EL element were evaluated in a manner similar to that used in Example 12. Table 1 shows the results.

### Example 22

An organic EL element was produced in the same manner as in Example 12, except that the high molecular weight compound V obtained in Example 5 was used instead of the high molecular weight compound II, and the high molecular weight compound I and the high molecular weight compound V were mixed in a weight ratio of 3:2. Various characteristics of this organic EL element were evaluated in a manner similar to that used in Example 12. Table 1 shows the results.

### Example 23

An organic EL element was produced in the same manner as in Example 12, except that the high molecular weight compound VI obtained in Example 6 was used instead of the high molecular weight compound II. Various characteristics of this organic EL element were evaluated in a manner similar to that used in Example 12. Table 1 shows the results.

### Example 24

An organic EL element was produced in the same manner as in Example 12, except that the high molecular weight compound VI obtained in Example 6 was used instead of the high molecular weight compound II, and the high molecular weight compound I and the high molecular weight compound VI were mixed in a weight ratio of 2:3. Various characteristics of this organic EL element were evaluated in a manner similar to that used in Example 12. Table 1 shows the results.

### Example 25

An organic EL element was produced in the same manner as in Example 12, except that the high molecular weight compound VI obtained in Example 6 was used instead of the high molecular weight compound II, and the high molecular weight compound I and the high molecular weight compound VI were mixed in a weight ratio of 3:2. Various characteristics of this organic EL element were evaluated in a manner similar to that used in Example 12. Table 1 shows the results.

### Comparative Example 1

An organic EL element was produced in the same manner as in Example 12, except that TFB (hole transporting polymer) below was used instead of the mixture of the high molecular weight compound I and the high molecular weight compound II.

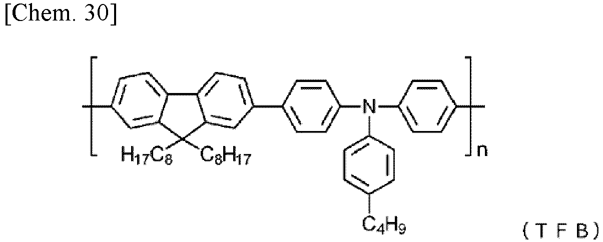

TFB (hole transporting polymer) is poly[(9,9-dioctylfluorenyl-2,7-diyl)-co-(4,4'-(N-(4-sec-butylphenyl))diphenylamine] (Hole Transport Polymer ADS259BE available from American Dye Source, Inc.). Various characteristics of this organic EL element of Comparative Example 1 were evaluated in a manner similar to that used in Example 12. Tables 1 and 2 show the results.

### Comparative Example 2

An organic EL element was produced in the same manner as in Example 12, except that only the high molecular weight compound I was used instead of the mixture of the high molecular weight compounds I and II. Various characteristics of this organic EL element were evaluated in a manner similar to that used in Example 12. Table 1 shows the results.

### Comparative Example 3]

An organic EL element was produced in the same manner as in Example 12, except that only the high molecular weight compound II was used instead of the mixture of the high molecular weight compounds I and II. Various characteristics of this organic EL element were evaluated in a manner similar to that used in Example 12. Table 1 shows the results.

### Comparative Example 4

An organic EL element was produced in the same manner as in Example 12, except that only the high molecular weight compound III was used instead of the mixture of the high molecular weight compounds I and II. Various characteristics of this organic EL element were evaluated in a manner similar to that used in Example 12. Table 1 shows the results.

### Comparative Example 5

An organic EL element was produced in the same manner as in Example 12, except that only the high molecular weight compound IV was used instead of the mixture of the high molecular weight compounds I and II. Various characteristics of this organic EL element were evaluated in a manner similar to that used in Example 12. Table 1 shows the results.

### Comparative Example 6

An organic EL element was produced in the same manner as in Example 12, except that only the high molecular weight compound V was used instead of the mixture of the high molecular weight compounds I and II. Various characteristics of this organic EL element were evaluated in a manner similar to that used in Example 12. Table 1 shows the results.

### Comparative Example 7

An organic EL element was produced in the same manner as in Example 12, except that only the high molecular weight compound VI was used instead of the mixture of the high molecular weight compounds I and II. Various characteristics of this organic EL element were evaluated in a manner similar to that used in Example 12. Table 1 shows the results.

Note that, in the evaluation of the various characteristics, the element lifespan was measured as follows: constant current driving was performed with the light emission luminance (initial luminance) when light emission started being set to 700 cd/m², and the time taken for the light emission luminance to decay to 490 cd/m² (corresponding to 70% of the initial luminance, which was taken as 100%: for a decay to 70%) was measured as the element lifespan.

**Table 1**

| | Hole transport layer 4 | Voltage [V] (@10 mA/cm²) | Luminance [cd/m²] (@10 mA/cm²) | Light emission efficiency [cd/A] (@10 mA/cm²) | Power efficiency [lm/W] (@10 mA/cm²) | Element lifespan for a decay to 70% (@700 cd/m²) |
|---|---|---|---|---|---|---|
| Ex. 12 | I + II = 1:1 | 4.29 | 867 | 8.67 | 6.35 | 124 h |
| Ex. 13 | I + II = 2:3 | 4.32 | 837 | 8.36 | 6.08 | 122 h |
| Ex. 14 | I + II = 3:2 | 4.25 | 814 | 8.13 | 6.02 | 137 h |
| Ex. 15 | I + III = 1:1 | 4.01 | 894 | 8.94 | 7.00 | 258 h |
| Ex. 16 | I + III = 2:3 | 4.05 | 905 | 9.05 | 7.03 | 278 h |
| Ex. 17 | I + III = 3:2 | 3.98 | 895 | 8.95 | 7.07 | 249 h |
| Ex. 18 | I + IV = 1:1 | 4.12 | 908 | 9.07 | 6.93 | 169 h |
| Ex. 19 | I + IV = 2:3 | 4.10 | 941 | 9.40 | 7.21 | 232 h |
| Ex. 20 | I + IV = 3:2 | 4.11 | 883 | 8.82 | 6.75 | 159 h |
| Ex. 21 | I + V = 1:1 | 4.23 | 875 | 8.39 | 6.49 | 290 h |
| Ex. 22 | I + V = 3:2 | 4.20 | 872 | 8.26 | 6.52 | 329 h |
| Ex. 23 | I + VI = 1:1 | 4.31 | 1007 | 10.07 | 7.34 | 209 h |
| Ex. 24 | I + VI = 2:3 | 4.33 | 967 | 9.67 | 7.02 | 94 h |
| Ex. 25 | I + VI = 3:2 | 4.28 | 898 | 8.98 | 6.60 | 159 h |
| Com. Ex. 1 | TFB | 4.11 | 534 | 5.34 | 4.08 | 14 h |
| Com. Ex. 2 | High molecular weight compound I | 3.89 | 757 | 7.56 | 6.12 | 72 h |
| Com. Ex. 3 | High molecular weight compound II | 4.48 | 889 | 8.89 | 6.23 | 22 h |
| Com. Ex. 4 | High molecular weight compound III | 4.28 | 905 | 9.06 | 6.64 | 65 h |
| Com. Ex. 5 | High molecular weight compound IV | 4.79 | 921 | 9.21 | 6.04 | 10 h |
| Com. Ex. 6 | High molecular weight compound V | 4.74 | 956 | 9.56 | 6.35 | 34 h |
| Com. Ex. 7 | High molecular weight compound VI | 4.83 | 497 | 4.97 | 3.23 | 0.9 h |

As shown in Table 1, with regard to the element lifespan (for a decay to 70%), the organic EL elements of Comparative Examples 1, 2, and 3, in which mixing of high molecular weight compounds was not performed, exhibited lifespans of 14 hours, 72 hours, and 22 hours, respectively, but the organic EL elements of Examples 12, 13, and 14, which had a mixed layer of the high molecular weight compounds I and II, all exhibited longer lifespans of 124 hours, 122 hours, and 137 hours, respectively.

Also, as shown in Table 1, with regard to the element lifespan (for a decay to 70%), the organic EL elements of Comparative Examples 1, 2, and 4, in which mixing of high molecular weight compounds was not performed, exhibited lifespans of 14 hours, 72 hours, and 65 hours, respectively, but the organic EL elements of Examples 15, 16, and 17, which had a mixed layer of the high molecular weight compounds I and III, all exhibited longer lifespans of 258 hours, 278 hours, and 249 hours, respectively.

Furthermore, as shown in Table 1, with regard to the element lifespan (for a decay to 70%), the organic EL elements of Comparative Examples 1, 2, and 5, in which mixing of high molecular weight compounds was not performed, exhibited lifespans of 14 hours, 72 hours, and 10 hours, respectively, but the organic EL elements of Examples 18, 19, and 20, which had a mixed layer of the high molecular weight compounds I and IV, all exhibited longer lifespans of 169 hours, 232 hours, and 159 hours, respectively.

Furthermore, as shown in Table 1, with regard to the element lifespan (for a decay to 70%), the organic EL elements of Comparative Examples 1, 2, and 6, in which mixing of high molecular weight compounds was not performed, exhibited lifespans of 14 hours, 72 hours, and 34 hours, respectively, but the organic EL elements of Examples 21 and 22, which had a mixed layer of the high molecular weight compounds I and V, both exhibited longer lifespans of 290 hours and 329 hours, respectively.

Furthermore, as shown in Table 1, with regard to the element lifespan (for a decay to 70%), the organic EL elements of Comparative Examples 1, 2, and 7, in which mixing of high molecular weight compounds was not performed, exhibited lifespans of 14 hours, 72 hours, and 0.9 hours, respectively, but the organic EL elements of Examples 23, 24, and 25, which had a mixed layer of the high molecular weight compounds I and VI, all exhibited longer lifespans of 209 hours, 94 hours, and 159 hours, respectively.

### Example 26

### <Production and Evaluation of Organic EL Element: Use of High Molecular Weight Compound Having No Thermal Crosslinkable Structural Unit>

An organic EL element having the layer structure shown in Fig. 21 was produced in the same manner as in Example 12, except that, instead of a high molecular weight compound having a thermal crosslinkable structural unit, a high molecular weight compound having no thermal crosslinkable structural unit was used as the hole transport layer 4.

Specifically, an organic EL element was produced in the same manner as in Example 12, except that the high molecular weight compound VII obtained in Example 7, which was a high molecular weight compound α having no thermal crosslinkable structural unit, and the high molecular weight compound VIII obtained in Example 8, which was a high molecular weight compound β having no thermal crosslinkable structural unit, were mixed in a weight ratio of 1:1, and the obtained mixture was used. Various characteristics of this organic EL element were evaluated in a manner similar to that used in Example 12. Table 2 shows the results.

### Example 27

An organic EL element was produced in the same manner as in Example 26, except that the high molecular weight compound VII and the high molecular weight compound VIII were mixed in a weight ratio of 2:3, instead of the weight ratio of 1:1. Various characteristics of this organic EL element were evaluated in a manner similar to that used in Example 26. Table 2 shows the results.

### Example 28

An organic EL element was produced in the same manner as in Example 26, except that the high molecular weight compound VII and the high molecular weight compound VIII were mixed in a weight ratio of 3:2, instead of the weight ratio of 1:1. Various characteristics of this organic EL element were evaluated in a manner similar to that used in Example 26. Table 2 shows the results.

### Example 29

An organic EL element was produced in the same manner as in Example 26, except that the high molecular weight compound IX obtained in Example 9 was used instead of the high molecular weight compound VIII. Various characteristics of this organic EL element were evaluated in a manner similar to that used in Example 26. Table 2 shows the results.

### Example 30

An organic EL element was produced in the same manner as in Example 26, except that the high molecular weight compound IX obtained in Example 9 was used instead of the high molecular weight compound VIII, and the high molecular weight compound VII and the high molecular weight compound IX were mixed in a weight ratio of 3:2. Various characteristics of this organic EL element were evaluated in a manner similar to that used in Example 26. Table 2 shows the results.

### Example 31

An organic EL element was produced in the same manner as in Example 26, except that the high molecular weight compound X obtained in Example 10 was used instead of the high molecular weight compound VII, the high molecular weight compound XI obtained in Example 11 was used instead of the high molecular weight compound VIII, and the high molecular weight compound X and the high molecular weight compound XI were mixed in a weight ratio of 2:3. Various characteristics of this organic EL element were evaluated in a manner similar to that used in Example 26. Table 2 shows the results.

### Example 32

An organic EL element was produced in the same manner as in Example 26, except that the high molecular weight compound X obtained in Example 10 was used instead of the high molecular weight compound VII, the high molecular weight compound XI obtained in Example 11 was used instead of the high molecular weight compound VIII, and the high molecular weight compound X and the high molecular weight compound XI were mixed in a weight ratio of 3:2. Various characteristics of this organic EL element were evaluated in a manner similar to that used in Example 26. Table 2 shows the results.

### Comparative Example 8

An organic EL element was produced in the same manner as in Example 26, except that only the high molecular weight compound VII was used instead of the mixture of the high molecular weight compounds VII and VIII. Various characteristics of this organic EL element were evaluated in a manner similar to that used in Example 26. Table 2 shows the results.

### Comparative Example 9

An organic EL element was produced in the same manner as in Example 26, except that only the high molecular weight compound VIII was used instead of the mixture of the high molecular weight compounds VII and VIII. Various characteristics of this organic EL element were evaluated in a manner similar to that used in Example 26. Table 2 shows the results.

### Comparative Example 10

An organic EL element was produced in the same manner as in Example 26, except that only the high molecular weight compound IX was used instead of the mixture of the high molecular weight compounds VII and VIII. Various characteristics of this organic EL element were evaluated in a manner similar to that used in Example 26. Table 2 shows the results.

### Comparative Example 11

An organic EL element was produced in the same manner as in Example 26, except that only the high molecular weight compound X was used instead of the mixture of the high molecular weight compounds VII and VIII. Various characteristics of this organic EL element were evaluated in a manner similar to that used in Example 26. Table 2 shows the results.

### Comparative Example 12

An organic EL element was produced in the same manner as in Example 26, except that only the high molecular weight compound XI was used instead of the mixture of the high molecular weight compounds VII and VIII. Various characteristics of this organic EL element were evaluated in a manner similar to that used in Example 26. Table 2 shows the results.

Note that, in the evaluation of the various characteristics, the element lifespan was measured as follows: constant current driving was performed with the light emission luminance (initial luminance) when light emission started being set to 700 cd/m², and the time taken for the light emission luminance to decay to 490 cd/m² (corresponding to 70% of the initial luminance, which was taken as 100%: for a decay to 70%) was measured as the element lifespan.

**Table 2**

| | Hole transport layer 4 | Voltage [V] (@10 mA/cm²) | Luminance [cd/m²] (@10 mA/cm²) | Light emission efficiency [cd/A] (@10 mA/cm²) | Power efficiency [lm/W] (@10 mA/cm²) | Element lifespan for a decay to 70% (@700 cd/m²) |
|---|---|---|---|---|---|---|
| Ex. 26 | VII + VIII = 1:1 | 3.90 | 775 | 7.74 | 6.23 | 1646 h |
| Ex. 27 | VII + VIII = 2:3 | 3.90 | 799 | 7.98 | 6.43 | 1889 h |
| Ex. 28 | VII + VIII = 3:2 | 3.93 | 765 | 7.64 | 6.11 | 1442 h |
| Ex. 29 | VII + IX = 1:1 | 3.92 | 851 | 8.50 | 6.81 | 1310 h |
| Ex. 30 | VII + IX = 3:2 | 3.86 | 798 | 7.98 | 6.49 | 1194 h |
| Ex. 31 | X + XI = 2:3 | 4.04 | 870 | 8.69 | 6.77 | 663 h |
| Ex. 32 | X + XI = 3:2 | 4.00 | 844 | 8.44 | 6.64 | 801 h |
| Com. Ex. 1 | TFB | 4.11 | 534 | 5.34 | 4.08 | 14 h |
| Com. Ex. 8 | High molecular weight compound VII | 3.95 | 769 | 7.69 | 6.12 | 1264 h |
| Com. Ex. 9 | High molecular weight compound VIII | 4.04 | 889 | 8.88 | 6.90 | 1064 h |
| Com. Ex. 10 | High molecular weight compound IX | 4.59 | 680 | 6.79 | 4.65 | 17 h |
| Com. Ex. 11 | High molecular weight compound X | 3.92 | 826 | 8.26 | 6.63 | 616 h |
| Com. Ex. 12 | High molecular weight compound XI | 4.27 | 910 | 9.09 | 6.69 | 78 h |

As shown in Table 2, with regard to the element lifespan (for a decay to 70%), the organic EL elements of Comparative Examples 1, 8, and 9, in which mixing of high molecular weight compounds was not performed, exhibited lifespans of 14 hours, 1264 hours, and 1064 hours, respectively, but the organic EL elements of Examples 26, 27, and 28, which had a mixed layer of the high molecular weight compounds VII and VIII, all exhibited longer lifespans of 1646 hours, 1889 hours, and 1442 hours, respectively.

Also, as shown in Table 2, with regard to the element lifespan (for a decay to 70%), the organic EL elements of Comparative Examples 1, 8, and 10, in which mixing of high molecular weight compounds was not performed, exhibited lifespans of 14 hours, 1264 hours, and 17 hours, respectively, but the organic EL elements of Examples 29 and 30, which had a mixed layer of the high molecular weight compounds VII and IX, both exhibited longer or approximately equal lifespans of 1310 hours and 1194 hours, respectively.

Furthermore, as shown in Table 2, with regard to the element lifespan (for a decay to 70%), the organic EL elements of Comparative Examples 1, 11, and 12, in which mixing of high molecular weight compounds was not performed, exhibited lifespans of 14 hours, 616 hours, and 78 hours, respectively, but the organic EL elements of Examples 31 and 32, which had a mixed layer of the high molecular weight compounds X and XI, both exhibited longer lifespans of 663 hours and 801 hours, respectively.

As can be seen from the foregoing description, it was found that an organic EL element including a mixed layer formed of two or more high molecular weight compounds according to the present invention can realize a longer lifespan while maintaining a lower voltage and higher efficiency, compared with a conventional organic EL element.

### Industrial Applicability

An organic EL element of the present invention has a low driving voltage, high efficiency, and a long lifespan, and can thus be used in applications such as home electrical appliances and lighting equipment, for example.

## Claims

1. An organic electroluminescence element having a pair of electrodes and at least one organic layer between the electrodes, wherein
the organic layer is constituted by two or more high molecular weight compounds including at least a high molecular weight compound α and a high molecular weight compound β, and
the high molecular weight compound α has a substituted triarylamine structural unit represented by a general formula (1) below and has a weight average molecular weight of 10,000 or more and less than 1,000,000 in terms of polystyrene: 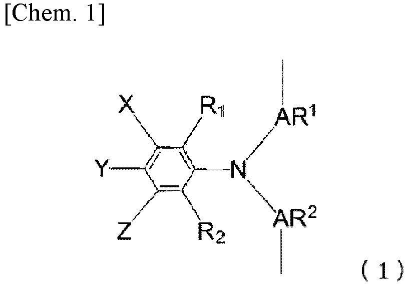
where AR¹ and AR² each independently represent a divalent aryl group or a divalent heteroaryl group,
R₁ and R₂ each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms, and
X, Y, and Z each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, a cycloalkyloxy group having 5 to 10 carbon atoms, an aryl group, or a heteroaryl group, where at least one of X, Y, and Z is an aryl group or a heteroaryl group.

2. The organic electroluminescence element according to claim 1, wherein, in the general formula (1), R₁ and R₂ each independently represent a hydrogen atom or a heavy hydrogen atom, and X and Y each independently represent an aryl group or a heteroaryl group.

3. The organic electroluminescence element according to claim 1, wherein, in the general formula (1), R₁ and R₂ represent hydrogen atoms, and X and Y each independently represent a phenyl group, a biphenylyl group, a terphenyl group, a naphthyl group, a phenanthrenyl group, a fluorenyl group, a naphthylphenyl group, a triphenylenyl group, a dibenzofuranyl group, or a dibenzothienyl group.

4. The organic electroluminescence element according to any one of claims 1 to 3, wherein the high molecular weight compound α has at least one structural unit selected from structural units that have an aromatic hydrocarbon ring and that are represented by general formulae (2a) to (2x) below: 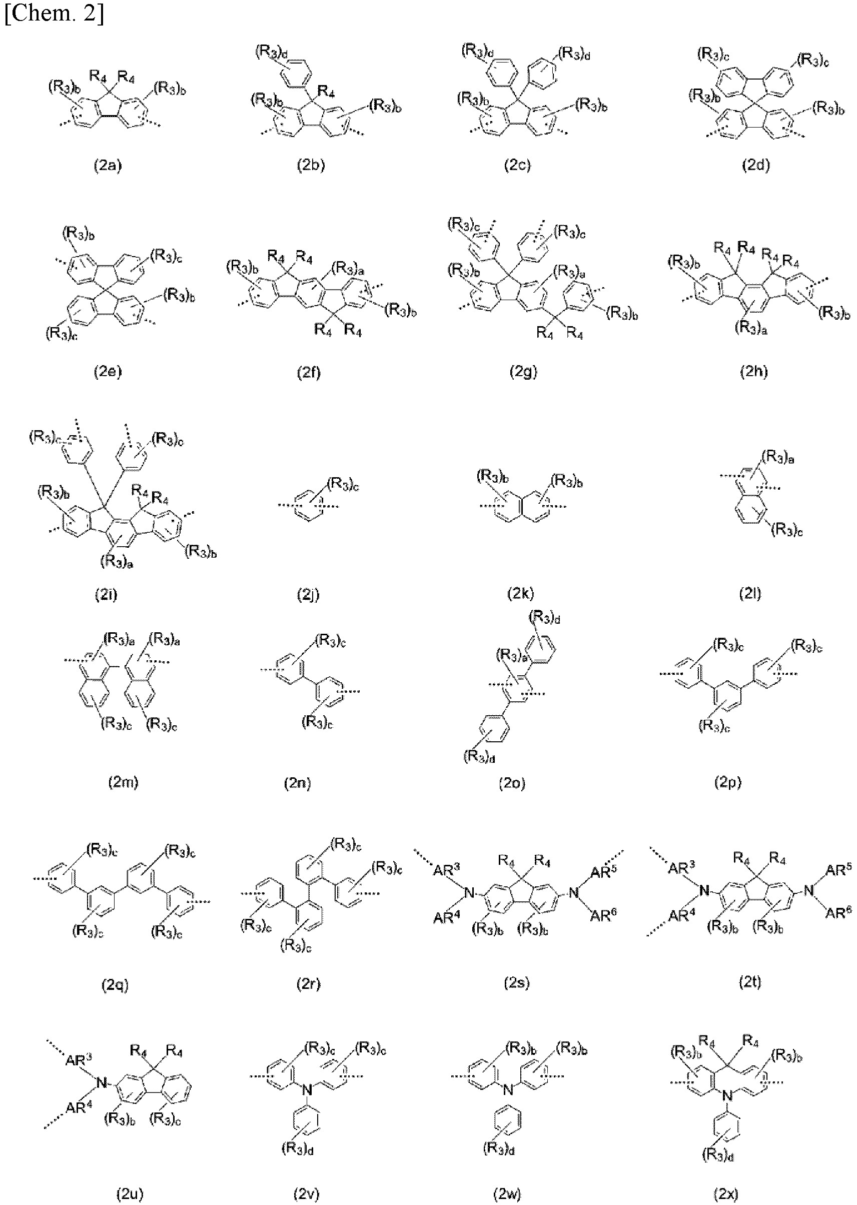
where R₃ each independently represent a heavy hydrogen atom, a cyano group, a nitro group, a fluorine atom, a chlorine atom, a bromine atom, an iodine atom, an alkyl group, a cycloalkyl group, an alkyloxy group, a cycloalkyloxy group, a thioalkyloxy group, an alkenyl group, or an aryloxy group, the alkyl group, the cycloalkyl group, the alkyloxy group, the cycloalkyloxy group, the thioalkyloxy group, the alkenyl and the aryloxy group having not more than 40 (in particular, 3 to 40) carbon atoms,
R₄ represents an alkyl group, a cycloalkyl group, an alkyloxy group, a thioalkyloxy group, or a cycloalkyloxy group, the alkyl group, the cycloalkyl group, the alkyloxy group, the thioalkyloxy group and the cycloalkyloxy group having not more than 40 (in particular, 3 to 40) carbon atoms,
AR³ to AR⁶ each independently represent a monovalent or divalent aryl or heteroaryl group, and
a to d are the numbers of R₃, and each independently represent an integer below:
a = 0, 1, or 2,
b = 0, 1, 2, or 3,
c = 0, 1, 2, 3, or 4, and
d = 0, 1, 2, 3, 4, or 5.

5. The organic electroluminescence element according to any one of claims 1 to 4, wherein the high molecular weight compound α has a thermal crosslinkable structural unit.

6. The organic electroluminescence element according to claim 5, wherein the thermal crosslinkable structural unit is at least one structural unit selected from structural units represented by general formulae (3a) to (3z) below: 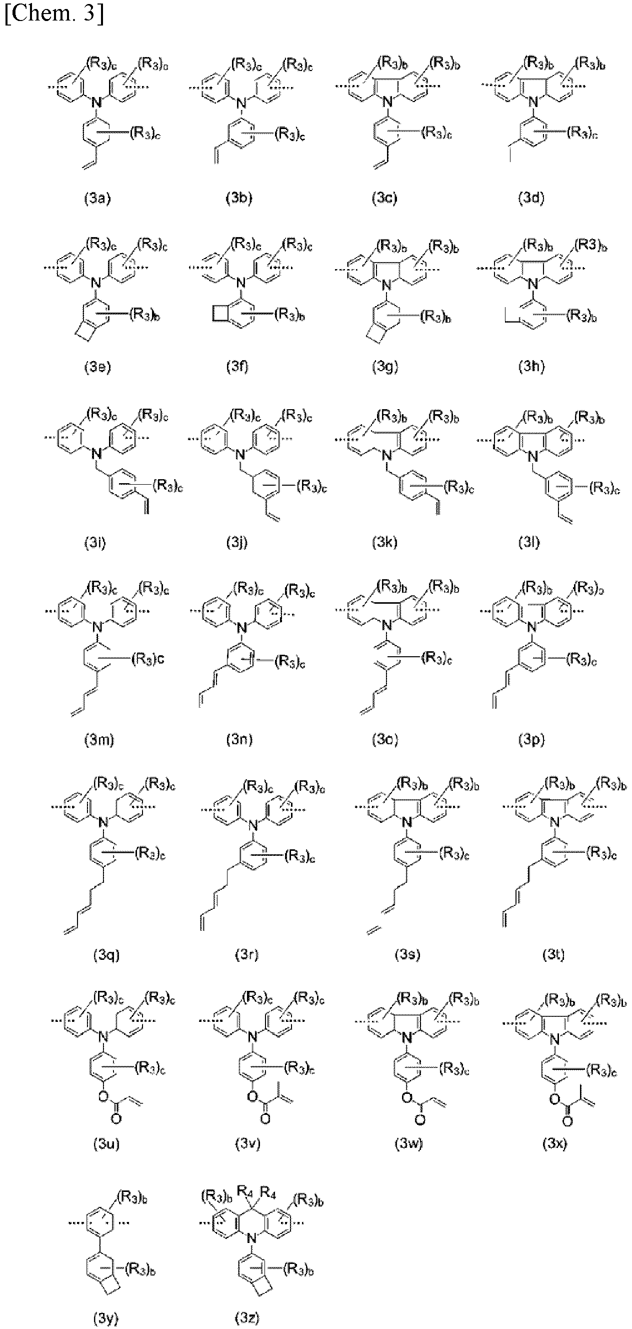
where R₃, R₄, and a to c are as defined in the general formulae (2a) to (2x).

7. The organic electroluminescence element according to any one of claims 1 to 6, wherein the high molecular weight compound β has a repeating unit constituted by a triarylamine structural unit represented by a general formula (4) below and a bonding structural unit represented by a general formula (5) below, wherein the repeating unit is represented by a general formula (6) below, and
the high molecular weight compound β has a weight average molecular weight of 10,000 or more and less than 1,000,000 in terms of polystyrene: 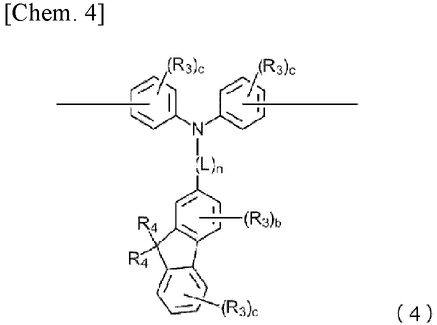 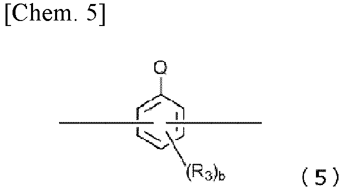 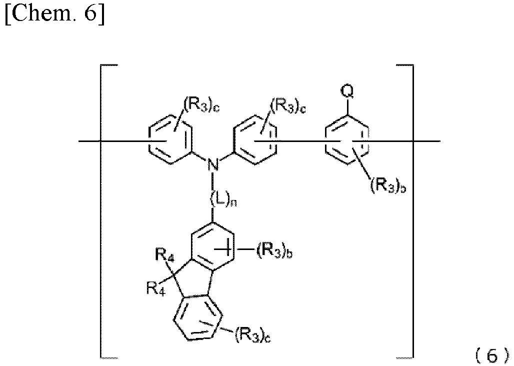
where R₃, R₄, b, and c are as defined in the general formulae (2a) to (2x),
Q represents a hydrogen atom, a heavy hydrogen atom, an amino group, an aryl group, or a heteroaryl group,
L represents a divalent phenyl group, and
n represents an integer of 0 to 3.

8. The organic electroluminescence element according to claim 7, wherein, in the general formula (6), R₃ is not present, or R₃ represents a heavy hydrogen atom, and Q represents a hydrogen atom or a heavy hydrogen atom.

9. The organic electroluminescence element according to claim 7 or 8, wherein the high molecular weight compound β has a thermal crosslinkable structural unit.

10. The organic electroluminescence element according to claim 9, wherein the thermal crosslinkable structural unit is at least one structural unit selected from structural units represented by the general formulae (3a) to (3z).

11. The organic electroluminescence element according to any one of claims 1 to 10, wherein the organic layer is a hole transport layer.

12. The organic electroluminescence element according to any one of claims 1 to 10, wherein the organic layer is an electron blocking layer.

13. The organic electroluminescence element according to any one of claims 1 to 10, wherein the organic layer is a hole injection layer.

14. The organic electroluminescence element according to any one of claims 1 to 10, wherein the organic layer is a light emitting layer.
